(19) Europäisches Patentamt
European Patent Office
Office européen des brevets

(11) EP 4 332 588 B1

(12) EUROPEAN PATENT SPECIFICATION

(45) Date of publication and mention
of the grant of the patent:
10.06.2026 Bulletin 2026/24

(51) International Patent Classification (IPC):
G01R 29/08 (2006.01)

(21) Application number: 22306307.4

(52) Cooperative Patent Classification (CPC):
G01R 29/0857

(22) Date of filing: 02.09.2022

(54) **DEVICE AND METHOD FOR THERMAL AND ELECTROMAGNETIC DOSIMETRY**

VORRICHTUNG UND VERFAHREN ZUR THERMISCHEN UND ELEKTROMAGNETISCHEN DOSIMETRIE

DISPOSITIF ET PROCÉDÉ DE DOSIMÉTRIE THERMIQUE ET ÉLECTROMAGNÉTIQUE

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR

(43) Date of publication of application:
06.03.2024 Bulletin 2024/10

(73) Proprietors:
• Université de Rennes
35042 Rennes (FR)
• Centre National de la Recherche Scientifique
75016 Paris (FR)
• Institut National des Sciences Appliquées de Rennes
35700 Rennes (FR)
• NANTES UNIVERSITÉ
44000 Nantes (FR)
• CentraleSupélec
91190 - Gif sur Yvette (FR)

(72) Inventors:
• BORYSKIN, Artem
35235 THORIGNE FOUILLARD (FR)
• ZIANE, Massinissa
35700 RENNES (FR)
• SAULEAU, Ronan
35690 ACIGNE (FR)
• ZHADOBOV, Maxim
35700 RENNES (FR)

(74) Representative: Plasseraud IP
104 Rue de Richelieu
CS92104
75080 Paris Cedex 02 (FR)

(56) References cited:
US-B2- 10 739 392

• YOSHINOBU OKANO ET AL: "Comparison Measurement for Specific Absorption Rate With Physically Different Procedure", IEEE TRANSACTIONS ON INSTRUMENTATION AND MEASUREMENT, IEEE, USA, vol. 61, no. 2, 1 February 2012 (2012-02-01), pages 439 - 446, XP011391185, ISSN: 0018-9456, DOI: 10.1109/TIM.2010.2045939
• SASAKI KENSUKE ET AL: "Design of a Skin Equivalent Phantom for Estimating Surface Temperature Elevation Due to Human Exposure to Electromagnetic Fields From 10 to 100 GHz", IEEE TRANSACTIONS ON ELECTROMAGNETIC COMPATIBILITY, IEEE SERVICE CENTER , NEW YORK , NY, US, vol. 63, no. 5, 10 September 2021 (2021-09-10), pages 1631 - 1639, XP011883095, ISSN: 0018-9375, [retrieved on 20211014], DOI: 10.1109/TEMC.2021.3100887
• SEUNGMO KIM ET AL: "Human Electromagnetic Field Exposure in Wearable Communications: A Review", ARXIV.ORG, CORNELL UNIVERSITY LIBRARY, 201 OLIN LIBRARY CORNELL UNIVERSITY ITHACA, NY 14853, 11 December 2019 (2019-12-11), XP081549654

## Description

## Technical Field

The invention relates to a device and method for electromagnetic dosimetry, and more particularly, the present invention relates to a device for measuring in a synchronized manner thermal information and electromagnetic information and retrieving the electromagnetic dosimetry quantities induced in a thermal medium, e.g a biological tissue, by electromagnetic fields emitted by an electromagnetic source.

## Background Art

With the development of the wireless technology, such as cellular phones and various user wireless devices which are used in contact with the human body, measuring precisely the exposure level of the radiation of the electromagnetic (EM) wave in a human body becomes a critical factor.

Various categories of devices reproducing electromagnetic properties of biological tissues, commonly named as "phantoms" for evaluating the exposure of the human body to electromagnetic waves exist: liquid phantoms, semi-solid phantoms, solid phantoms as well as hybrid phantoms. The liquid phantom comprises a plastic part or a solid shell filled with a gel or a liquid having similar EM properties to those of the human biological tissues at the measurement frequency typically provided thanks to a high content of water, like in biological tissues. these devices are generally used in the frequency ranges from 30 MHz to 6 GHz. These devices have several problems: the liquid needs to be changed frequently due to the evaporation and/or the degradation of the dielectric properties of the liquid over time. These devices require special test equipment to support their weight. The use of the such devices at frequencies above 6GHz is not possible due to the strong absorption of the EM field by water molecules, leading to a very shallow EM field penetration depth and thus insufficient signal-to-noise ratio (SNR) for embedded sensors. Composition of the semi-solid phantoms is similar to the liquid phantom and a jellifying agent is usually used instead of a liquid to retain the shape of the phantom without using a solid shell. Their main drawback is a limited lifetime (typically limited to days or weeks). The solid phantom is a solid piece made of solid dielectric material, like plastic, polymer, ceramic or synthetic rubbers doped with conductive particles such as graphite, carbon, or metal. The main advantage thereof is the reliability and the constancy of the dielectric properties thereof over time. However, these devices are quite complex and costly to manufacture. Furthermore, they also suffer from high EM losses that do not allow the measurement above 10 GHz due to the frequency-dependent EM properties of the phantom materials. For instance, at 60 GHz, the penetration depth of electromagnetic radiation in the human tissues is of the order of 0.5 mm and the absorption of radiation is essentially limited to the superficial layers of the body. This leads to a prohibitively low signal-to-noise ratio (SNR) for any sensor embedded in a phantom reproducing the EM properties of said biological tissue.

In this perspective, due to the specificity of the frequency-dependent interaction between the human body and the wireless devices, leading to lower reflection and simultaneously to stronger EM losses, and the compliance testing of wireless devices of 5G and beyond generations operating at frequencies above 6 GHz, the new dosimetry standards and guidelines imply the use of a new dosimetric quantity, i.e. absorbed power density (APD) averaged over a certain area, instead of the specific absorption rate (SAR) averaged over a certain volume as used at frequencies below 6 GHz. Moreover, in view of the potentially strong mutual impact of the human body on the 5G device performance characteristics (and thus the user exposure levels), the new guidelines also imply the testing of such devices in realistic conditions, taking into account the presence of the human body. These two requirements make obsolete the existing EM dosimetry devices used for testing 3G/4G devices.

In addition, to meet the demand for increasing data rates and traffic volumes, new frequency bands in the frequency range from about 24 GHz to 300 GHz will be employed in the 5G and forthcoming generation of wireless communication systems, thanks to the new radio access technologies developed for the mmWave frequency bands, wide-band spectral signals, beam-forming, multi-input multi-output (MIMO), and dynamic resource allocation in the time, frequency and spatial domains.

The mmWave spectrum allocated in different countries for 5G and future 6G wireless systems includes multiple sub-bands in the licensed (e.g. 24 - 28 GHz, 37-39 GHz, 47 GHz) and unlicensed (e.g. 60 GHz) spectrum, whose bandwidth can vary across different countries.

The available spectrum within each band is divided in multiple channels with carrier sizes standardized for lower mmWave sub-bands as 50 MHz, 100 MHz, 200 MHz, and 400 MHz. The frequency and time resource allocation can be done in the centralized or distributed modes in a certain manner that can also vary for different types of 5G wireless devices. The channel capacity can be further increased by frequency reuse and/or multiplexing in the time, spatial and polarization domains.

The higher propagation loss at mmWaves is compensated by higher antenna gains achieved using compact antenna arrays and the multiple input multiple output (MIMO) technologies. The beam-forming capabilities enabled in 5G devices are used to multiplex parallel data streams to communicate with spatially separated multiple users or to mitigate the dynamic blockage of a propagation channel with a single user. The portable and wearable devices often containing 4-8 antenna elements, which allows to support at least two different beams, characterized by different shape/width, gain, and/or spatial orientation.

Thus, recent wireless communication devices have more than one antenna and are able to operate in multiple frequency bands and modes, supporting various radio access technologies. In case of the 5G devices, the additional degree of complexity will be added because of the dynamic resource allocations in time, frequency, and spatial domains. The existing methods for electromagnetic (EM) dosimetry developed for compliance testing of 3G/4G devices operating below 6GHz cannot be applied for 5G mmWave devices due to the fundamental limitations of all the existing technologies, either related to their inability to reproduce the realistic use case conditions, to take into account the dynamic resource allocation, or due to the prohibitively low SNR caused by the high material and propagation EM losses at mm-waves. This calls for development of new dosimetric systems capable of overcoming these limitations.

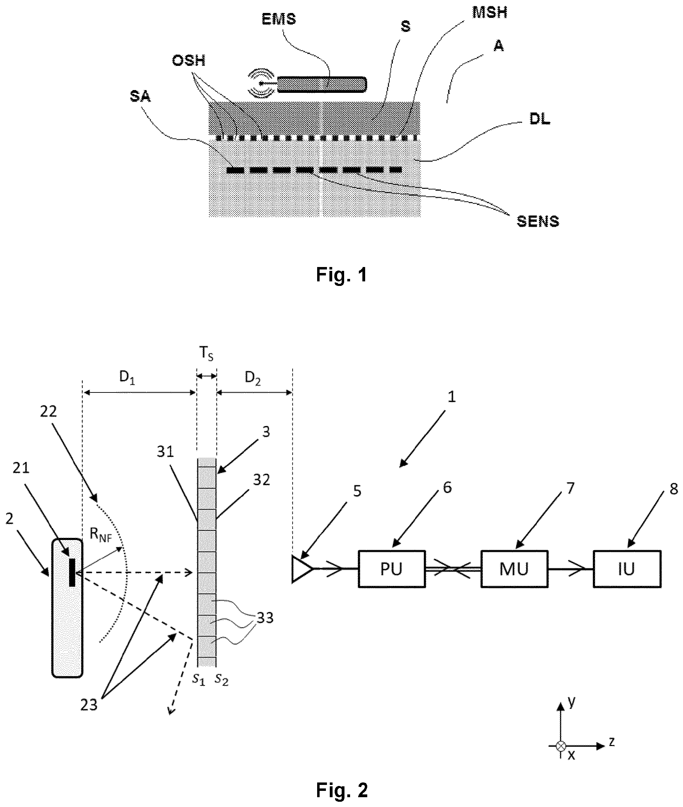

The document WO2017/0173350 and with reference to figure 1, proposes a device having characteristic of human tissues while being able to measure electromagnetic waves at frequencies greater than 6 GHz. It comprises one layer of a dielectric material (S), a semitransparent metal shield (MSH) with through holes (OSH) and an array of sensors (SENS) placed below the through holes. The sensors are configured to measure the electromagnetic field emitted by an electromagnetic source (EMS).

Although the device proposed in this document offers the reliability and the constancy of the dielectric properties and potentially allows electromagnetic dosimetry at frequencies above 6 GHz, the proposed solution does not teach how to reduce or limit the significant losses of the electromagnetic field intensity during its propagation through the compound dielectric material dopped with conductive microparticles (such as carbon) that results in strong absorption of the electromagnetic field at high frequencies, in particular above 6 GHz.

Moreover, similarly to other prior art solutions, the measurement procedure used in WO2017/0173350 relies on sampling of the transmitted field in a plurality of space points defined by positions of the sensors in the array of sensors (SENS). This may cause inaccuracies due to the fixed mesh of the sampling points dictated by the array of sensor topology and/or due to the additional postprocessing steps of digital integration of the measured quantities in order to compute a dosimetric quantity defined for a given surface area or volume.

The high EM losses may sacrifice the accuracy of the measurements and reduce the signal-to-noise ratio (SNR). In order to increase the SNR, that is a critical parameter for low-power measurements, it is necessary to increase either the sensitivity of sensors or the level of the transmitted electromagnetic signal. The latter is usually preferred as it allows to deal with a higher noise level. However, it is not doable for low-power devices operating in the mm-wave frequency range due to the limited power and high material losses at these frequencies for standard dielectric materials. These limitations can be critical in terms of accuracy and cost of the dosimetry device for compliance testing of $5^{th}$ and beyond generations of wireless devices.

In addition, the prior art device proposed in that document does not take into account the specificity of the 5G devices as for dynamic resources allocations in the time, frequency and spatial domains that may lead to rapid changes in the exposure conditions.

Therefore, there is a need for an improved device and method for electromagnetic dosimetry, which allows to take into account the specificity of the 5G devices as for dynamic resource allocation (by taking into account the sophisticated time and frequency resource allocation enabled by 5G and future xG devices leading to non-constant exposure conditions), as well as to improve the signal-to-noise ratio (SNR) of the measured signals by developing methods and techniques not based on direct EM measurement, thus enabling a more accurate, reliable, and fast method and device for user exposure compliance testing of 5G/xG wireless devices under realistic exposure conditions.

Another aim of the present invention is to propose a device which allows to convert the unavoidable electromagnetic loss in the phantom material into a measurable physical quantity, i.e. local heat, correlated with the sought dosimetric quantity, thus providing an alternative approach for building the EM dosimetry system.

Another aim of the present invention is to provide a device which is easier and less expensive to manufacture.

Y. Okano and H. Shimoji, "Comparison Measurement for Specific Absorption Rate With Physically Different Procedure," in IEEE Transactions on Instrumentation and Measurement, vol. 61, no. 2, pp. 439-446, Feb. 2012 describes a thermal specific absorption rate (SAR) measurement method using an optical fiber thermal sensor.

K. Sasaki et al., "Design of a Skin Equivalent Phantom for Estimating Surface Temperature Elevation Due to Human Exposure to Electromagnetic Fields From 10 to 100 GHz," in IEEE Transactions on Electromagnetic Compatibility, vol. 63, no. 5, pp. 1631-1639, Oct. 2021 describes a semisolid human-body phantom for simulating the steady-state temperature elevation at the skin surface due to exposure to millimeter waves (MMWs) and quasi-MMWs was developed in this article.

US10739392B2 describes a device for simulating characteristics of human tissues in electromagnetic dosimetry. The device includes a substrate bearing a metallized shielding, a layer of a dielectric material arranged on or beneath the substrate and the device includes a plurality, of openings made in the shielding and at least an array of sensors in the layer of dielectric material.

## Summary

This disclosure improves the situation.

It is proposed a device according to claim 1 for measuring an electromagnetic dosimetric quantity received by an object illuminated by an electromagnetic (EM) field emitted by an electromagnetic source, comprising:

- a screen comprising a top surface faced to the electromagnetic source and a bottom surface opposite to the top surface, said screen being adapted to absorb at least a portion of the EM field emitted by the electromagnetic source;
- the screen comprising a plurality unit cells;
- at least one thermal sensor arranged relative to the bottom surface of the screen and configured to measure a physical quantity relative to the heat distribution along a surface of the screen induced due to the absorption of the electromagnetic field in the screen medium;
- a processing unit linked to the at least one thermal sensor and configured to calculate the electromagnetic dosimetric quantities from the measured heat distribution, the information relative to the EM field emitted by the EM source, and the predetermined EM and thermal properties of the screen.

The device further comprises at least one electromagnetic sensor configured to measure the information relative to the EM field emitted by the EM source.

In a preferred embodiment, the processing unit is configured to correlate in time the information relative to the EM field measured by the least on electromagnetic sensor and the heat distribution measured by the at least one thermal sensor to calculate the electromagnetic dosimetric quantities

In another embodiment, the processing unit is configured to analyze the signal transmitted from the at least one electromagnetic sensor to retrieve the information relative to the EM field emitted by the EM source.

In an embodiment, the at least one electromagnetic sensor is linked to the electromagnetic source by a control link.

In one further embodiment, the processing unit is configured to use a lock-in technique to postprocess the time-lapse heat distribution by using a predetermined lock-in frequency and waveform relative to the EM field emitted by the EM source.

In an embodiment, the at least one thermal sensor is a thermal sensor positioned at a distance from the bottoms surface of the screen and aligned with respect to the screen center, to the center of a unit cell, and/or along the direction of the EM wave propagation

In yet another embodiment, the at least one thermal sensor comprises a plurality of thermocouples attached to or embedded in the bottom surface of the thermal screen.

In an embodiment, the at least one thermal sensor comprises at least one thermosensitive element, attached to the bottoms surface of the screen.

In an embodiment, the at least one electromagnetic sensor is an electromagnetic sensor operating at the frequency range overlapping at least partly the operational frequency range of the electromagnetic source.

In another embodiment, the at least one electromagnetic sensor is configured to measure the incident EM field from the EM source, the EM field reflected from the top surface of the screen, or the EM field transmitted through the screen.

In an embodiment, the screen comprises at least one first dielectric layer comprising a top surface faced to the electromagnetic source and a bottom surface opposite to the top surface;

- said top surface being at least partly transparent to the electromagnetic fields emitted by the source;
- said bottom surface being at least partly reflecting for the electromagnetic fields transmitted through the at least one first dielectric layer;
- said at least one first dielectric layer characterized by a complex dielectric permittivity and a thickness jointly chosen to reproduce the electromagnetic response of a reference object, e.g. a biological tissue, a human skin tissue.

In another embodiment, the thermal screen comprises two dielectric layers, the first dielectric layer having a top surface faced to the electromagnetic sensor and the second dielectric layer having a bottom surface faced to the thermal sensor, each layer characterized by a complex dielectric permittivity and thickness jointly chosen to reproduce the electromagnetic response of a reference object, each layer comprising a plurality unit cells.

In another embodiment, the thermal screen comprises two dielectric layers, the first dielectric layer having a top surface faced to the electromagnetic sensor and the second dielectric layer having a bottom surface faced to the thermal sensor, each layer characterized by a complex dielectric permittivity and thickness jointly chosen to reproduce the electromagnetic response of a reference object, each layer comprising a plurality of unit cells, the unit cells being separated by groves, the groves being filled in or made of a dielectric material having a thermal conductivity smaller than that of the dielectric material of the second dielectric layer.

In yet another embodiment, the screen comprises a first dielectric layer, a second dielectric layer and a third layer, the second layer is made of a dielectric material having a thermal conductivity smaller than that of the third layer, each layer characterized by a complex dielectric permittivity and thickness jointly chosen to reproduce the electromagnetic response of a reference object, each layer comprising a plurality of unit cells, the unit cells of the third layer being separated by groves, the groves being filled in or made of a dielectric material having a thermal conductivity smaller than that of the dielectric material of the third dielectric layer.

In another embodiment, the screen comprises a first dielectric layer, a second dielectric layer and a third layer, each layer characterized by a complex dielectric permittivity and thickness jointly chosen to reproduce the electromagnetic response of a reference object, each layer comprising a plurality unit cells, the unit cells of the second layer being separated by groves, the groves being filled in or made of a dielectric material having a thermal conductivity smaller than that of the dielectric material of the second dielectric layer, the third layer being made of a thermosensitive material.

In another aspect, it is proposed a method according to claim 15 of detecting an electromagnetic dosimetric quantity received by an object illuminated by an electromagnetic (EM) field emitted by an electromagnetic source, the method comprising :

- illuminating, using an EM source, a surface of a thermal screen;
- converting the EM field incident on the surface of the thermal screen into heat induced in the thermal screen ;
- measuring the information relative to the induced heat by the at least one thermal sensor;
- measuring the information relative to the EM field, emitted by the EM source, by an EM sensor;
- determining a time-lapsed temperature rise distribution at a set of time moments $\tau_i$ in a time interval $[\tau_1, \tau_2]$ by a processing unit using information relative to the induced heat;
- correlating in time the information relative to the time-lapsed temperature rise distribution and the information relative to the EM field emitted by the EM source;
- calculating the electromagnetic dosimetric quantities using correlated in time the information relative to the time-lapsed temperature rise distribution and to the EM field emitted by the EM source, and the predetermined information relative to the EM and thermal properties of the screen.

In an embodiment, the method further comprises a step:

- comparing the signal to noise ratio (SNR) of the time-lapsed temperature rise distribution to a predetermined threshold value;
- improving the SNR by using the information relative to the EM field.

In another embodiment, the completion of the measurement procedure is defined with respect to the convergence of a numerical solution of a time-reverse EM and thermal model used for calculating the EM dosimetric quantities.

**Brief Description of Drawings**

Other features, details and advantages will be shown in the following detailed description and on the figures, on which:

**Fig. 1**
[Fig. 1] Figure 1 is a schematic illustration of a cross-sectional view of a device for electromagnetic dosimetry of the prior art.
**Fig. 2**
[Fig. 2] Figure 2 is a schematic illustration of a cross-sectional view of an embodiment of a device for electromagnetic dosimetry, not covered by the claims.
**Fig. 3**

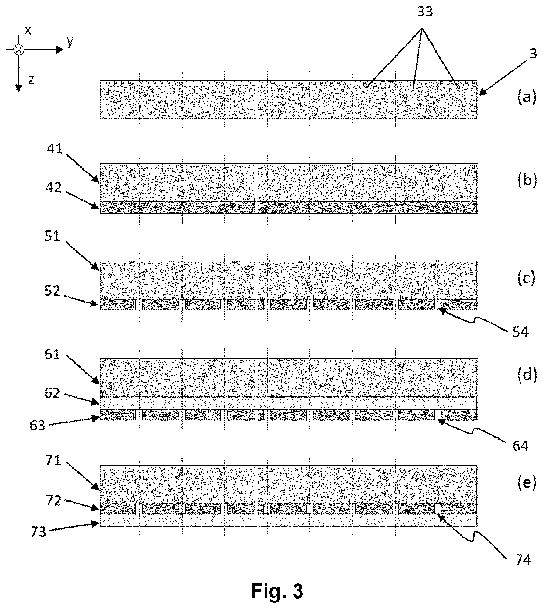

[Fig. 3] Figure 3 represents non-limiting examples of a screen configured to absorb at least a portion of the electromagnetic power radiated by the electromagnetic source at a given operational frequency of the electromagnetic source: a single layer comprising a plurality of unit cells (a), two layers comprising a plurality of unit cells (b), two dielectric layers with the second layer comprising a plurality of unit cells separated with groves (c), three layers comprising an intermediate layer having a thermal conductivity lower than that of the bottom layer (d), three layers comprising a bottom layer made of a thermosensitive material (e).
**Fig. 4**

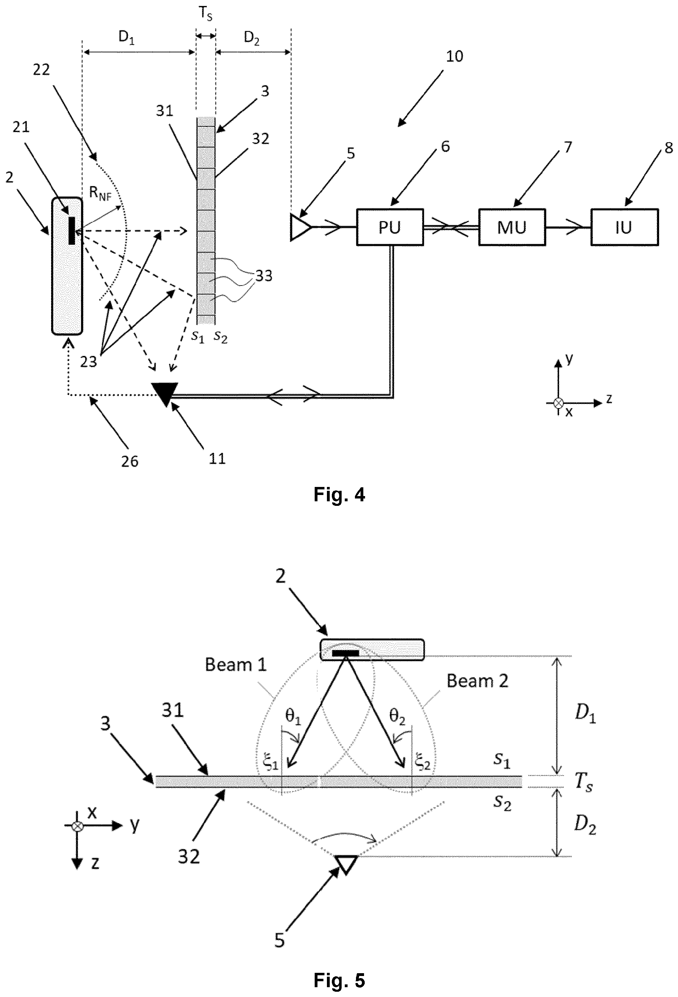

[Fig. 4] Figure 4 is a schematic illustration of a cross-sectional view of an embodiment of a device for electromagnetic dosimetry.
**Fig. 5**
[Fig. 5] Figure 5 is a schematic illustration of a cross-sectional view of one embodiment not covered by the claims, of a device for electromagnetic dosimetry applied for measuring a user exposure level in a screen illuminated by two differential spatial beams of electromagnetic radiation emitted by the electromagnetic source.
**Fig. 6**

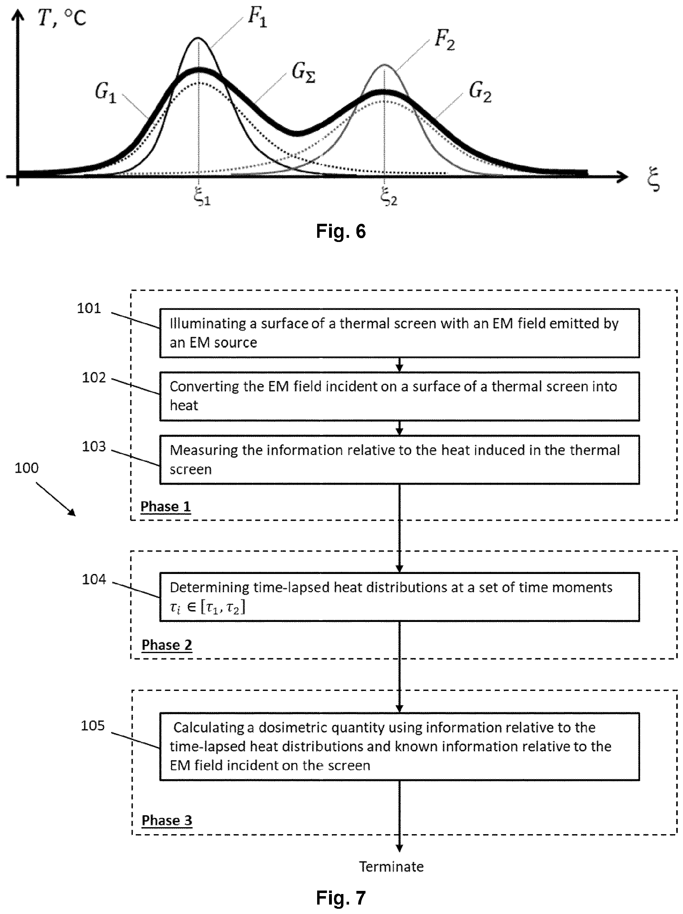

[Fig. 6] Figure 6 is a schematic illustration of an exemplary temperature rise distribution at the bottom surface of the screen after a short exposure along $\xi$ coordinate, $\xi$ being x or y : measured temperature profile (thick line, $G_\Sigma(\xi)$), temperature patterns associated with two overlapping hot spots induced by the absorbed electromagnetic fields retrieved through decomposition of the measured temperature profile (thin doted, $G_1(\xi)$, $G_2(\xi)$), estimated temperature patterns in a screen with zero thermal conductivity (thin solid, $F_1(\xi)$, $F_2(\xi)$).
**Fig. 7**
[Fig. 7] Figure 7 is an illustration of a method for calculating a dosimetric quantity implemented using the device of figure 2 in accordance with an embodiment not covered by the claims.

**Fig. 8**

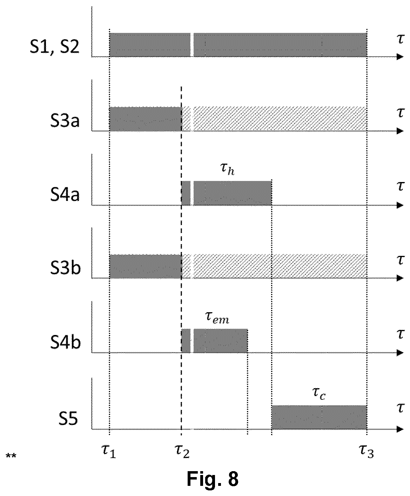

[Fig. 8] Figure 8 is an illustration of the different time intervals of the main steps performed in a method for calculating a dosimetric quantity, by measuring in a correlated manner the thermal and EM information, implemented using the device of figure 4 according to an embodiment.

**Fig. 9**

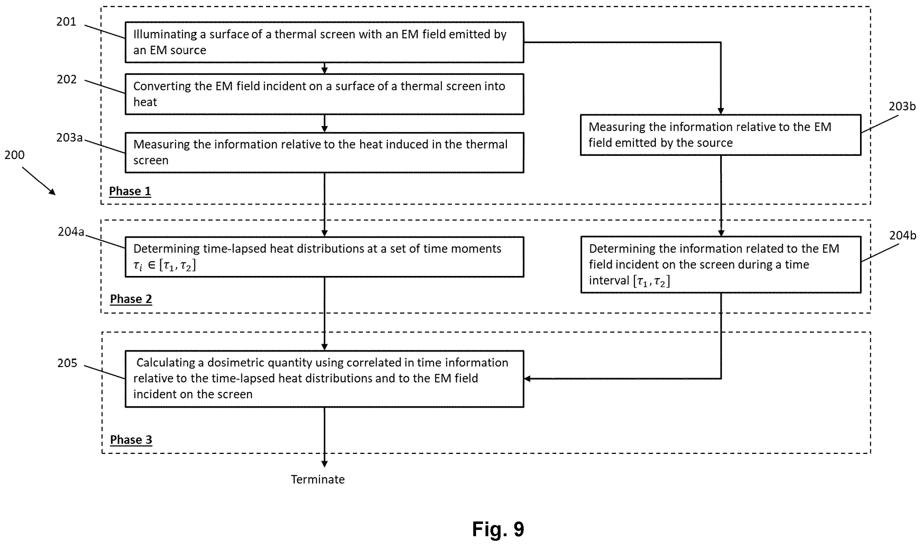

[Fig. 9] Figure 9 is a flow chart depicting steps of a method for calculating a dosimetric quantity implemented using the device of figure 4 according to an embodiment.

**Fig. 10**

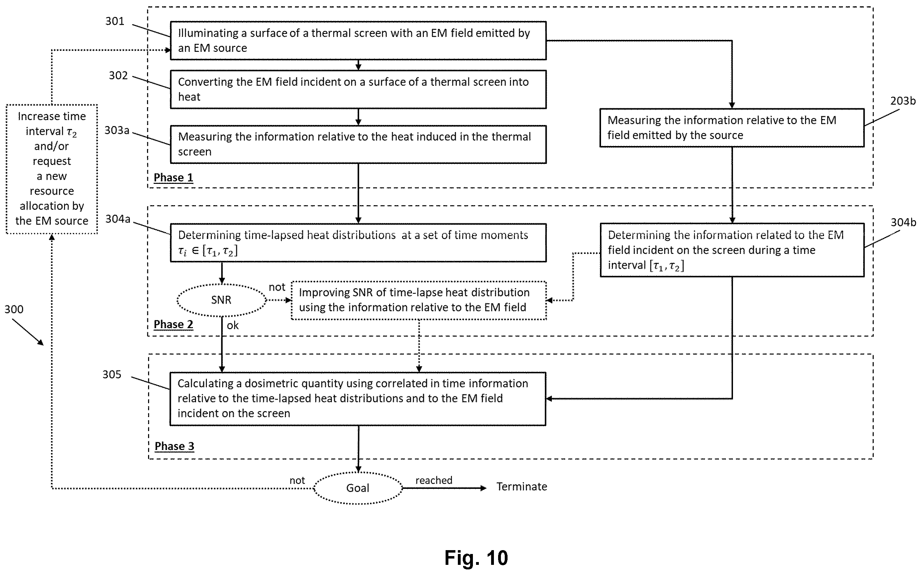

[Fig. 10] Figure 10 is a flow chart depicting steps of a method for calculating a dosimetric quantity implemented using the device of figure 4 according to another embodiment.

**Description of Embodiments**

The terms "top," "bottom," "over," "under," "between," "on", and other similar terms as used herein refer to a relative position. The relative position of the terms does not define or limit the layers to a vector space orientation.

To facilitate understanding, identical reference numerals have been used, where possible, to designate identical elements that are common to the figures. It is contemplated that elements disclosed in one embodiment may be beneficially utilized on other embodiments without specific recitation.

In the present disclosure, the term "layer" refers to a structure having a constant thickness or a variable thickness. The layer may be planar or curved. In particular, the layer may be shaped to reproduce a 3D form of a part of a human body, e.g. head or hand. The layer may be shaped to form a closed surface such the surface of a side wall of a cylindrical object.

In the present disclosure, the term "dosimetric quantity" or "physical quantity" refers to any metric used to quantify the electromagnetic exposure, including power density, energy density, specific absorption rate, specific energy absorption, electric field strength, magnetic field strength, electric voltage or current as well as their derivatives defined with respect to an averaging surface area or volume.

In the present disclosure, the term "information of the EM field" refers to any information related to the resource allocation used by the source in the frequency, time and/or spatial domains, for instance, frequency channel and frequency band used for transmission, waveform and time blocks used for scheduled transmission, radiated power, radiation diagram, polarization, phase center position, antenna architecture etc.

In the present disclosure, the terms "thermal medium" or "thermal screen" refer to a medium designed to convert in a controlled manner the electromagnetic field incident on the surface of the medium into heat. The thermal medium acts as a spatial converter of the EM field into heat induced in the volume of the medium due to the absorption of a portion of the EM power transmitted through the thermal medium.

In the present disclosure, the term "electrically conductive layer" refers to a layer made of material having electrical conductivity $\sigma \geq 10^3$ S/m.

In the present disclosure, the term "dielectric layer" refers to a layer made of thermally conductive and electrically insulating material having electrical conductivity $\sigma$ strictly smaller than $10^3$ S/m.

With reference to figure 2, a device 1 for dosimetry electromagnetic according to an unclaimed embodiment of the present disclosure will now be described. In this embodiment, the proposed device combines the thermal measurements and a specific thermal screen with predetermined thermal and known electromagnetic parameters to retrieve electromagnetic quantities related to exposure level by an electromagnetic source.

The device 1 is placed in an orthogonal spatial coordinate system (XYZ).

The thermal screen of the device 1 is advantageously designed to have a predetermined EM response to incident EM field characterized by a predetermined frequency, polarization, and incident angle. In one embodiment, it can be designed to provide a low reflection to allow a larger portion of the incident power to penetrate inside the thermal screen. Alternatively, it can be configured to reproduce the electromagnetic response of a reference object, such as an anatomic part of the human body, when this reference object is illuminated by an electromagnetic source; in particular, reflection characteristics at the air/skin interface and to measure a physical quantity related to the electromagnetic field incident on the thermal screen representing the reference object. The measured physical quantity may be a function of the amplitude of the EM field, intensity and/or power density of the EM field incident on or transmitted through the air/dielectric interface.

The device 1 comprises a thermal screen 3 extending sensibly along a plane (XY), a thermal sensor 5 and a processing unit 6 (PU). The device further comprises a memory unit 7 (MU) and an interface unite 8 (IU). The figure 2 shows the device placed in a test configuration. An electromagnetic source 2 is disposed at a distance $D_1$ to the device 1.

**Electromagnetic source**

The electromagnetic field source 2 may be a mobile phone or any other wireless device stationary, portable, or wearable. This distance $D_1$ is preferably larger than the antenna near field zone characterized by $R_{NF}$ represented by a wave front line in figure 2. For an electrically small antenna, the reactive near-field zone is approximately defined with respect to the wavelength as $R_{NF} = \lambda_0 / 2\pi$, where $\lambda_0$ is the wavelength in vacuum. For example, at 60 GHz, the distance $R_{NF}$ is about 0.8 mm.

The one skilled in the art will easily adapt the value of this distance $D_1$ to guarantee an accurate compliance test, representative of a realistic use case situation, such as a mobile phone close to the head of the user. The distance $D_1$ and the position of the wireless device under test depend on the intended use cases defined by manufacturer of the wireless device and/or by mobile operators. For instance, said distance can vary in the range from a few mm (for a smartphone close to a head) to a few tens of cm (for a hand-held device).

The electromagnetic source 2 may comprise one or more antennas connected to or embedded in the body of the source for transmitting and/or for receiving electromagnetic signals.

As shown in figure 2, the electromagnetic field source 2 comprises one single antenna 21 which emits an electromagnetic field represented by the wave front line 22. The center of the wave front line coincides with a phase center of the antenna 21. A portion of the electromagnetic wave emitted by the source 2 illuminates a surface 31 of the thermal screen 3 of the device 1. This surface illuminated by the EM wave emitted by the source 2 is called a top surface. The surface of the thermal screen 3 of the device 1 which is opposite to the EM source is called bottom surface 32.

The EM source 2 may operate at frequencies in a band within the frequency range from about 6 GHz to about 300 GHz allocated for the 5G and 6G wireless networks, however the teaching of this invention can be scaled to other frequency bands, thanks to the scalability of the Maxwell equations.

As shown in figure 2, the EM wave emitted by the source 2 is incident on the top surface 31 of the thermal screen 3. The incident EM wave is designated by the numeric reference 23. The incident wave is partly reflected by the top surface 31 of the screen 3 (not represented in figure 2). A portion of the EM wave that is not reflected at the air/screen interface associated with the top surface 31 propagates through the screen 3, from the top surface 31 to the bottom surface 32 and is partly absorbed in the medium of the screen 3. The EM wave transmitted through the screen 3 induces a temperature rise within the screen 3.

The electromagnetic source 2 may operate with a single antenna which generates a single beam fixed in time, in space and in frequency. In another embodiment, the electromagnetic source may comprise more than one antenna and be adapted to operate in multiple frequency bands, allowing a dynamic resource allocation in time, frequency, and spatial domains. The dynamic resource allocation may concern the variable in time allocation of the communication resources (frequency-time blocks and transmit powers), as well as the use of one of at least two predetermined spatial diagrams of the radiated power enabled by a beam-forming mechanism. For instance, the EM source may use only one of a plurality of frequency channels and its transmission may be scheduled in time domain. Thus, the beam generated by each source may be variable in time and in frequency.

**Thermal Screen**

The thermal screen 3 acts as a spatial converter of the EM field into heat induced in the volume of the screen due to the absorption of a portion of the EM power transmitted through the screen in the medium of said screen. In one embodiment, the screen can represent a phantom structure which reproduces the electromagnetic response of a reference object made of an electromagnetic lossy medium, such as a biological tissue, when its surface is illuminated by an electromagnetic wave emitted by an electromagnetic source. As non-limiting examples, the screen structure may comprise at least one dielectric layer made of any solid dielectric material characterized by a complex dielectric permittivity, such as plastic, polymer, ceramics, glass, resin or paper. The one skilled in the art will easily adapt the different values of the complex permittivity and thickness of the at least one dielectric layer to the embodiments described in relation with the present invention.

The thermal screen 3 is adapted to absorb at least a portion of the EM power radiated by the EM source, which is incident on the screen and transmitted through its surface.

The thermal screen 3 comprises a structure extending in a horizontal plane (XY). The structure defines two main surfaces, a top surface 31 face toward the electromagnetic source and a bottom surface 32 opposite with respect to the electromagnetic source 2.

The screen may be made of a dielectric material being absorbing at a frequency $F_1$ being the operational frequency of the electromagnetic source 2 under test and varying between the minimum of $F_1$ and the maximum of $F_2$, for example between 24 - 28 GHz, or between 37 - 39 GHz, or between 57-71 GHz, or within another sub-band in the frequency range above 6 GHz.

The thickness of the thermal screen $T_S$ along z-axis orthogonal to the thermal screen is preferably comprised between $\lambda_1/10$ and $10 \times \lambda_1$, where $\lambda_1$ is the wavelength of the EM field in the medium of the dielectric layer 3 at frequency $F_1$. For instance, the thickness of the dielectric layer $T_1$ may be about 1 mm at 60 GHz.

The thermal screen 3 is preferably positioned at a predetermined distance $D_1$ form the electromagnetic source in a manner to provide an air gap between the electromagnetic source and the screen. For example, $D_1$ is chosen to be greater than $\lambda_1/100$, $\lambda_1$ being the wavelength of the EM field in free space at frequency $F_1$. This distance can also be defined according to the intended use of the EM source 2. For instance, in case of a smart phone it can be defined as 5mm which is a typical distance of a smartphone when placed close to the head of a user.

In one embodiment, the screen forms a 2D planar structure as illustrated in figure 2, having larges dimension in the xy- plane, e.g much larger than the thickness Ts extending along the z-axis. The overall size of the screen can be defined according to the intended use of the EM source 2. For instance, it can be selected equal to the head or hand of the user. Alternatively, it can be selected in accordance with radiation diagram of the source 2 or an expected near or far field distribution in the plane of the screen produced by the source 2 to allow its characterization with minimum number of measurements under a fixed relative position of the source 2 and the screen 3.

In another embodiment, the screen forms a complex 3D shape, reproducing the shape of a part the human body. In other words, the single dielectric layer 3 forms a closed or partly closed shell filled in with a medium, e.g. liquid, gel, foam, or gas. This 3D structure is particularly adapted to simulate the case of a part of a human body, e.g. head-like phantoms. The medium may be chosen to act as the brain and the top surface may present a concave surface in a manner to simulate the form of a head. Alternatively, the medium can be used solely as a mechanical support and/or a host medium for the at least one thermal sensor 5 placed beneath the dielectric layer 3.

In another example, the screen 3 may comprise a layer of an amorphous and gel type dielectric material doped with conductive filling, forming a suspension-type composite material. The percentage of the conductive filling may be varied to reproduce the electromagnetic response of a reference object, such as the reflection characteristics at the air-dielectric interface of the human skin tissue.

The screen is divided into a plurality of adjacent unit cells 33. In one embodiment, these cells can be all identical. The dimension of the unit cells is identical. Each cell is characterized by the same electromagnetic features and thermal features. In other words, the unit cells are made of same material and have the same configuration.

In another embodiment, the unit cells can be non-identical. Each unit cell is characterized by a specific size, its own electromagnetic features, and its own thermal features. In other words, the unit cells can be made of different dielectric material, and may have different size and/or shape. The dimension and the electromagnetic and/or thermal properties of each unit cell are adjusted to take into account the different illumination conditions of each cell by the electromagnetic field emitted by the source 2. The unit cells are designed to improve efficiency of the EM field to heat conversion under different illumination conditions and/or to prevent the heat spread in the plane of the screen.

Advantageously, the size of the unit cells in the middle of the screen and on its periphery can vary to take into account different illumination conditions which depend on at least the incident angle of the electromagnetic field on the top surface of the screen, the power density, and/or the polarization.

For example, the peripheral unit cells have larger size to compensate the lower incident power density and/or the difference in the reflection/transmission coefficients for the TE and TM polarized EM waves at grazing angles. The minimum size of the unit cells can vary from a fraction of the wavelength in the Screen medium at frequency $F_1$ to a few said wavelengths. The minimum size of the unit cell may also depend on the type of the thermal sensor used. For instance, it can be order of 100 microns for thermocouple (to easy integration) and to be an order of a micron in case of an infrared imaging sensor (to match its resolution limit). The maximum size can be defined rather arbitrary. For instance, it can beneficially be defined as 10x10mm or 20x20mm which is the averaging surface area defined in the ICNIRP (International Commission on Non-Ionizing Radiation Protection) recommendations for the EM dosimetry at mm-waves.

In a configuration wherein the device comprises a plurality of electro-thermal sensors or electro-optical sensors, the total number of cells can be equal to the number of thermal Sensors. In another embodiment wherein the device comprises a thermal infrared image sensor, the total number of unit cells can be smaller or equal to the number of pixels of the thermal infrared image sensor.

Thanks to this specific cellular architecture of the screen, the plurality of unit cells characterized by an anisotropic thermal conductivity can help to mitigate the heat conduction phenomenon in the plane of the screen, thus leading to a better resolution and a lower distortion of the measured time lapse heat distributions.

In the unclaimed embodiment of figure 2, the screen is used to convert the absorbed electromagnetic power when the EM waves propagates through the layer 3 into heat. The device of the present invention comprises a thermal sensor to measure the heat distribution along a surface of the screen to determine the absorbed EM power. The device further comprises a processing unit 6 (PU) configured to calculate a sought dosimetric quantity, e.g. user exposure level, by correlating the absorbed EM power, the known EM and thermal features of the screen and the known illuminations conditions defined by the relative position of the source 2 and information relative to the electromagnetic field emitted by the source 2.

**Thermal sensor**

The thermal sensor 5 is positioned beneath the bottom surface 32 of the thermal screen 3, at a distance $D_2$, on the opposite side with respect to the electromagnetic source 2. The thermal sensor 5 is configured to measure the temperature or heat induced in the screen medium due to the absorbed EM power.

In an embodiment, the device comprises a single thermal sensor 5 which is aligned with respect to the screen, along the direction of the electromagnetic wave propagation. The thermal sensor is centered and face toward the bottom surface 32 of the screen. The thermal sensor 5 may be an image sensor, such as an infrared or visible light image sensor.

The image sensor is configured to have a field of view which covers at least a portion of the bottom surface of the screen. In other words, the thermal sensor may have a field of view covering at least one unit cell.

The thermal image sensor is configured to operate in a spectral range comprising at least a portion of the EM spectrum emitted by the bottom surface 32 of the screen. For instance, this can be a portion of the infrared spectrum emitted by a heated medium or a portion of the visible spectrum emitted or reflected by a thermosensitive medium.

The thermal sensor 5 is configured to measure a temperature rise distribution on the screen. This temperature rise distribution is related to the heat induced by the electromagnetic power partly absorbed in the screen medium during the exposure duration. The screen can act simultaneously as a phantom structure to simulate the EM response and as a heat converting element absorbing the EM power and converting it into the heat re-emitted as infrared radiation measured by the thermal sensor 5.

In another embodiment, the thermal sensor 5 comprises a plurality of thermo-electric elements, commonly referred as thermocouples, embedded in the bottom surface of the screen or attached to the bottom surface of the screen. The thermocouples are electrical devices consisting of two dissimilar electrical conductors forming an electrical junction producing a temperature-dependent voltage, as a result of the Seebeck effect.

In yet another embodiment, the thermal sensor 5 comprise a plurality of thermo-sensitive elements, for example a liquid crystal or GaAs semiconductor crystal, attached to the bottom surface of the screen. These thermo-sensitive elements are adapted to convert heat into measurable physical quantity, for instance, a spectral shift of the emitted or reflected light.

The thermal sensor 5 may be any other sensor capable of measuring a physical quantity related to the heat induced in the screen.

**Processing unit**

As shown in figure 2, the signal captured by the thermal sensor 5 is transmitted to the processing unit 6. Knowing the electromagnetic properties of the screen and the information relative to the EM field emitted by the source 2, the processing unit 6 is capable to calculate the sought dosimetric quantity related to the EM radiation absorbed by the screen during a predetermined exposure duration. The processing unit 6 is configured to calculate the heat distribution at the bottom surface 32 of the thermal screen 3 by processing the information relative to the induced heat at different time moments during the exposure, called hereafter as "time-lapsed heat distribution". It can further be configured to calculate the sought dosimetric quantity (e.g. transmitted or absorbed power density) by applying the Maxwell and heat conduction equations in the medium of the screen with predetermined electromagnetic and thermal properties.

**Memory unit**

The processing unit 6 communicates with the memory unit 7 and the interface unit 8. The memory unit 7 is configured to store the data related to the signal acquired by the thermal sensor, information relative to the EM field emitted by the source, and the processed data. The memory unit 7 can store the time-lapse thermal profiles from the thermal sensor, the information about the thermal and electromagnetic properties of the screen, the illumination conditions for each unit cell of the screen, and the processed data, such as, for instance, transmitted and/or absorbed power density averaged per surface area and per time unit.

**Interface unit**

The interface unit 8 is configured to receive and transmit data to a user. The interface unit may further comprise a display unit allowing to display the time-lapse thermal profiles. The interface unit 8 may transmit data to another device equipped with a display unit. The interface may be typically a computer console. The user interface makes it possible to supervise operations carried out by the different elements of the device, by activating and/or controlling them, and to exchange information with it. It thus makes it possible to decide initialization and calculations, to define illumination conditions, to display the retrieved results for visualization.

Figure 7 depicts a method 100 for detecting the dosimetric quantity received by an object illuminated by an electromagnetic (EM) field emitted by an electromagnetic source. The method 100 is implemented using the device of figure 2 described above, and thus is described below with reference to figure 2.

The method comprises a first phase corresponding to a measurement phase comprising the following steps.

At step 101, the EM field 23 is emitted by the source 2 in the direction of the top surface of the thermal screen. In this embodiment, a known resource allocation in time, frequency and spatial domains from the source 2 specification is used to generate the EM field.

At step 102, the EM field 23 emitted by the source is converted into heat as a result of absorption of a portion of the EM field in the medium of the screen 3.

At step 103, the thermal sensor 6 acquires information relative to the heat induced in the screen at different time moments. This step may comprise a step of measuring of a physical quantity proportional to the induced heat by at least one thermal sensor 5. In one embodiment, the thermal sensor may be an infrared image sensor and the physical quantity may be the intensity of the infrared radiation emitted from the bottom surface 32 of the thermal screen. In another embodiment, the bottom surface 32 is covered with a thermosensitive material and the thermal sensor is an image sensor, the physical quantity may be the intensity of the visible light emitted or reflected by the bottom surface 32 of the screen. In yet another embodiment, the thermal sensors 5 comprise a plurality of thermocouples attached to or embedded in the bottom surface 32 of the screen, the physical quantity may be a voltage measured by a voltmeter. The information related to the heat can be stored in the memory unit 7 and/or displayed by the interface unit 8.

The second phase comprises the following step.

At step 104, the processing unit calculates the time-lapsed heat distributions at a set of time moments by processing the time sequence of the plurality of heat distribution for each point of measurement, pixel or unit cell. Depending on the type of the thermal sensor used, this step may comprise the following intermediate steps of :

- time averaging for a period of $\Delta\tau$;
- space averaging for a unit cell surface area of the bottom surface 32;
- converting a physical quantity measured by the thermal sensor into heat distribution along the bottom surface 32 of the thermal screen defined in terms of the absolute temperature or a relative temperature rise at a set of time moments during the exposure.

The third phase comprises the following step.

At step 105, the processing unit reconstructs the illumination conditions for each pixel (or unit cell) based on the information relative to the EM field emitted by the source 2 and its relative position. Thus, knowing the electromagnetic and thermal properties of the screen and the parameters of the electromagnetic wave incident on each pixel (cell unit) of the screen at each time moment, the processing unit 6 calculates the dosimetric quantity associated with the EM radiation incident on, transmitted through, and/or absorbed by the screen at each point of measurement, pixel or cell unit, by using information relative to the time-lapsed heat distributions calculated at step 104 and known information relative to the EM field incident on the screen.

Figure 3 represents non limiting examples of the thermal screen 3 which is configured to measure heat distribution needed to retrieve the dosimetric quantity in the plane of the screen exposed by the EM fields emitted by the EM source 2. In one embodiment, the reflection of the EM fields emitted by the source from the top surface of the thermal screen can be tailored to reproduce the electromagnetic response from a reference object, e.g., a human body.

The screen (a) of figure 3 comprises a single layer 3 which is characterized by a specific combination of the complex dielectric permittivity and thickness to generate a desired electromagnetic response from the surface of the layer, for instance as required to reproduce the corresponding electromagnetic response from the upper surface of a reference object, for example a biological tissue such as human skin. In one embodiment, the thickness of this single layer is chosen at least equal to 1/4 of wavelength of the EM wave in the medium of the single layer, said medium characterized by a predetermined complex dielectric permittivity whose modulus is smaller than that of the medium of the reference object. Alternatively, this single layer can be represented by a thin film with the thickness much smaller than the wavelength of the EM wave in the medium of the single layer, said bulk medium characterized by a predetermined complex dielectric permittivity whose modulus is larger than that of the medium on the reference object. These selected equivalence criteria can be defined at least for a portion of the frequency spectrum, at least one polarization, and at least a range of incident angles of the EM field radiated by the EM source and incident on the top surface of the screen.

The single layer 3 comprises a plurality of unit cells. In one embodiment, the layer is made of dielectric material. The dielectric layer 3 may be made of dielectric material dopped with conductive fillers, such as particles or a material comprising inclusions of another material characterized by a different value of the complex permittivity. The material of the layer, the type of the doping and its volume ratio is chosen to have the complex dielectric permittivity required, for a given thickness $T_S$ of the layer 3, to reproduce the desired electromagnetic response, from the top surface 31 of the layer 3, such as the complex reflection coefficient or its magnitude. For example, the reference object is a human skin tissue, the complex dielectric permittivity, and the thickness $T_s$ of the dielectric layer 3 can be selected to reproduce the magnitude of the complex reflection coefficient from the surface of the human skin whose typical value varies in the range of 0.75 to 0.4 in the frequency range of 6 GHz to 300GHz, respectively.

The screen (b) of figure 3 comprises a first dielectric layer 41 and a second dielectric layer 42. Each layer comprises a plurality of unit cells. Each dielectric layer is characterized by its own thickness, its own complex dielectric permittivity, and its own thermal conductivity. This second layer allows to adjust, to increase or decrease the reflection from the bottom surface of the first layer, at the first layer-second layer interface, depending on the ratio between the permittivity of the medium of the first layer 41 and that of the second layer 42.

The screen (c) of figure 3 comprises a first dielectric layer 51 and a second dielectric layer 52. Each layer comprises a plurality of unit cells. Each dielectric layer is characterized by its own thickness, its own complex dielectric permittivity, and its own thermal conductivity. In addition, the unit cells of the second layer 52 are separated by groves. The groves are filled in or made of another dielectric material having a thermal conductivity smaller than that of the material of the second layer 52 to mitigate the heat spread in the xy-plane leading to a thermal cross-talk between neighboring cells.

The screen (d) of figure 3 comprises a first dielectric layer 61, a second dielectric layer 62 and a third layer 63. The second layer 62 is made of a dielectric material having a thermal conductivity smaller than that of the third layer. Each layer comprises a plurality of unit cells. The unit cells of the third layer are separated by groves 64, the groves being filled in or made of a dielectric material having a thermal conductivity smaller than that of the dielectric material of the third dielectric layer 63. The lower thermal conductivity of the second layer 62 allows to mitigate the thermal heat spread along z-axis (between the third and first layers), as well as along the xy-plane in the medium of the first layer which is thermally isolated from the third layer by the second layer.

The screen (e) of figure 3 comprises a first dielectric layer 71, a second dielectric layer 72 and a third layer 73. Each layer characterized by a complex dielectric permittivity and thickness jointly chosen to reproduce the electromagnetic response of a reference object. Each layer comprises a plurality of unit cells. The unit cells of the second layer 72 are separated by groves 74. The groves are filled in or made of a dielectric material having a thermal conductivity smaller than that of the dielectric material of the second dielectric layer 72, to mitigate the heat spread along the xy-plane. The third layer 73 is made of a thermosensitive material.

The figure 4 is a schematic illustration of an embodiment of an EM dosimetry device 10 combining at least one electromagnetic sensor 11 to obtain the information relative to the EM field emitted by the source 2 and a thermal sensor 5 to measure a physical quantity related to the heat induced in the screen medium.

The device of figure 4 enables to obtain information relative to the EM field emitted by the EM source 2 via real-time monitoring of the EM fields in at least one space point and at a set of time points during the exposure time $[\tau_1, \tau_2]$ to determine time/frequency/spatial resource allocation used by the electromagnetic source 2 at each time moment during the test duration, as well as the illumination conditions for each pixel (or unit cell) of the screen at each time moment.

The information relative to the EM field emitted by the source 2 may comprise any portion of information related to the radio resource allocation used by the source 2 in the frequency, time and/or spatial domains. In one embodiment, it may concern at least the frequency channel used for transmission, which is the essential information for the determination of the corresponding values of the frequency-dependent EM properties of the screen, such as complex dielectric permittivity. It may further concern the amplitude and phase of the incident EM field in the location of the at least one EM sensor 11, to allow determination of the EM source 2 position and orientation needed to calculate the wave front and polarization of the incident field at each point of the screen surface or each unit cell. In yet another embodiment, it may concern the waveform in the time domain.

The information relative to the heat induced in the screen 3 measured by the thermal sensor 5 can be then synchronized with the EM information relative to the EM field incident on the top surface of the thermal screen determined based on the information obtained by the electromagnetic sensor 11 on the time/frequency/spatial resource allocation used by the electromagnetic source 2 during the test in order to enable post-processing and retrieval of dosimetric quantities from the measured heat distribution for an unknown EM source (i.e. without having a preliminary knowledge of the resource allocation used by the source 2 or in case if source 2 is using a dynamic time-varying resource allocation).

The step of collecting information relative to the heat induced in the screen and the step of collecting information relative to the EM field emitted by the source start at the same time. In other words, the thermal sensor and the EM sensor start the measurements at the same time.

The device 10, similar to the device 1 of figure 2, comprises a thermal screen 3 extending sensibly along a plane (XY), a thermal sensor 5 and a processing unit 6 (PU). The device further comprises a memory unit 7 (MU) and an interface unite 8 (IU). The figure 4 shows the device placed in a test configuration. An electromagnetic source 2 is disposed at a distance $D_1$ to the device 10. In addition, the device 10 comprises an electromagnetic sensor 11.

The proposed device allows to characterize a wireless device having limited or no information about the number of antennas, their position and orientation inside the electromagnetic source, their radiation pattern, their phase center position and the operational frequency, as well as the time/frequency/spatial resource allocation that can dynamically vary during the test.

The thermal screen 3, the EM source 2 and the thermal sensor 5 have been previously described in reference to figure 2.

The electromagnetic sensor 11 may comprise at least an RF front end and an RF receiver and is configured to receive the electromagnetic waves emitted by the electromagnetic source 2 to determine parameters of the incident EM field in the location of the EM sensor 11. It can further be configured to convert the information carried by them to a usable form. The EM sensor 11 is configured to detect at least one of the parameters of the incident electromagnetic field: power density, amplitude and phase of the E and/or H field, polarization, frequency and waveform. The EM sensor 11 is configured to detect any additional parameters related to the time and frequency resources allocation of the electromagnetic source 2. Furthermore, the EM sensor may be able to detect parasite EM fields emitted by other EM sources distinct from the electromagnetic source 2 used for the dosimetry test. The information relative to the parasite EM fields may be used to correct the data related to the heat induced by the EM field received by the screen.

As shown in figure 4, the EM sensor 11 is arranged relative to the EM source 2 to detect the EM field 23 emitted by the EM source. The EM sensor is aligned with the EM source for reliable detection of the EM field in a light of sight mode. This allows to obtain information relative to the EM field emitted by the EM source 2 that may comprise intensity of the EM field radiated by the EM source 2 or magnitude and phase of the E and/or H-field defined at an arbitrary set of time moments during the test. In addition, this information may comprise any portion of information related to the radio resource allocation by the source in the frequency, time and/or spatial domains. This information may comprise, for example, frequency channel and resource blocks used for transmission, waveform and time blocks for scheduled transmission. This information can further be postprocessed by the processing unit 6 to retrieve information about the illumination condition for each point of measurement, pixel (or unit cell) of the screen 3 at different time moments.

In one embodiment, the EM sensor 11 may be attached to or embedded in the top surface of the screen 3. The configuration of figure 4 shows the EM sensor 11 positioned at a given distance from the EM source and the screen.

In another embodiment, the EM sensor is arranged relative to the screen to capture the EM field reflected from the top surface of the screen in a multipath mode. In this embodiment, the EM sensor 11 may be positioned at a certain distance from the screen 3. Alternatively, it may be attached to or embedded in the top surface of the screen 3.

In yet another embodiment, the EM sensor is arranged beneath the bottom surface of the screen to capture the EM field transmitted through the screen. In this embodiment, the EM sensor may be placed below the screen or, alternatively, attached to or embedded in the bottom surface of the screen 3.

The device 10 may comprise more than on EM sensor. The additional EM sensor are configured to detect a complementary portion of the information relative to the EM field emitted by the EM source, e.g. to cover a complementary portion of the frequency range of the operational frequencies of the EM source 2, a sub-range of the incident angles of the incident EM fields, one of the two polarizations. This embodiment is particularly useful when the EM source comprises more than one antenna. For example, each EM sensor is associated with an antenna to measure the EM field emitted under certain illumination conditions, e.g incident angle, frequency, polarization, modulation. The use of plurality of EM sensors covering only a portion of the information allows to simplify architecture of the RF front ends, by reducing their operational bandwidth and/or restricting the measurement to only one polarization.

In yet another embodiment, the device comprises at least three EM sensors distributed in space around the EM source. The EM sensors are configured to measure the amplitude and/or phase of the incident EM fields. The information relative to phase of the EM field collected by these EM sensors can be used to determine the phase center position of the emitting antenna and thus to detect switching between different beams generated by the antenna, if the EM source is equipped with beam-forming and/or MIMO antenna system, or to detect switching between different antennas if the EM source is equipped with more than one antenna.

In yet another embodiment, the EM sensor 11 is integrated in the EM source 2 which can operate as EM receiver. For instance, the source 2 provided with two RF front ends uses a first antenna for transmission and a second antennas for detecting the EM fields reflected from the screen. In other words, the EM source is configured to support two operational modes simultaneously, e.g emitting the EM field towards the top surface of the screen and receiving the EM field reflected from the top surface of the screen. The information relative to the EM field emitted by the source, retrieved from the EM signals received by the second antenna, can further be delivered to the processing unit 6 through a control link 26. In one embodiment, this control link may be a wireless link established through the EM sensor 11. Alternatively, the control link may be established through the application layer, provided that both the processing unit 6 and the source 2 can be configured to support such connections. Depending on the source PHY, MAC and APP layer architectures, said information relative to the EM field emitted by the source during the test time may be directly accessible to the processing unit 6 through a common protocol.

The operational frequency range of the EM sensor may cover at least a portion of the EM source operational frequency range. In another embodiment, the operational frequency range of the EM sensor can be wider than the EM source operational frequency range to allow detection of parasitic EM waves.

As shown in figure 4, the output of the thermal sensor is linked to the input of the processing unit 6. The input of the memory unit is linked to the processing unit 6.

The processing unit 6 is configured to process the EM signal transmitted from the at least one EM sensor to retrieve the information relative to the EM field emitted by the source 2 to reconstruct illumination condition at the top surface 31 of the thermal screen at the time moments during the exposure.

The processing unit 6 is configured to calculate the dosimetric quantity, using information related to the induced heat from the thermal sensor 5 and the information related to the EM field and the information related to the thermal screen 3, by correlating the time-lapsed heat distribution with the information related to the illumination conditions for each pixel (or unit cell) of the top surface 31 of the thermal screen. The information relative to the EM field predetermined or detected by the EM sensor correlated in time with the information relative to the heat detected by the thermal sensor allows to retrieve a dosimetric quantity relative to the exposure level of an object by the EM source averaged per a predetermined time duration and/or surface area. The step of time correlation between the time-lapse heat distribution and the information relative to the EM field acquired by the EM sensor during the test allows a more accurate and reliable post-processing and the retrieval of the dosimetric quantities from the measured heat distribution.

In one embodiment, the device 10 of figure 4 comprises an EM transmitter configured to actively control the EM source operation during the test in a manner to impose a given time/frequency/spatial resource allocation.

The EM transmitter is arranged relative to the source 2 within the zone of radio coverage. In another embodiment, the EM transmitter is embedded in the top surface of the screen or attached to the top surface of the screen.

The EM transmitter may be combined with the EM sensor. In this configuration, the EM sensor may comprise at least one RF front end and one transceiver capable of operating in a half-duplex or full-duplex mode. As shown in figure 4, the EM sensor 11 is linked to the EM source 2 by a control link 26. Alternatively, for high-end wireless devices the control link 26 can be organized through the APP layer.

The use of the control link 26 allows the processing unit 6 through the EM sensor 11 to actively control the resource allocation of the source 2. This may concern the selection of the communication parameters of the time/frequency block and the adaptive power level, as well as beam-switching and MIMO regimes.

In this configuration, the EM transmitter can pilot the EM source to adjust the information relative to the EM field, e.g., emission power, frequency, polarization, waveform of the EM fields leading to the optimal signal-to-noise ratio for heat distribution measured by the thermal sensor 5.

In a preferred embodiment, the processing unit 6 is configured to use a transient thermography technique, which is a known technique based on the periodic pulse excitation, to retrieve the low amplitude temperature distributions buried by the ambient thermal noise. In this configuration, the processing unit 6 is configured to determine the optimal parameters of transient technique (namely the waveform and lock-in frequency of the periodic pulses) that are translated into the optimal information relative to the EM field emitted by the source 2. This optimal information is transmitted to the EM transmitter which controls the EM source through the control link 26.

In such a way, the processing unit 6 can configure the source 2 to generate a modulated input signal with a predetermined lock-in frequency and waveform. Knowing this information, the processing unit 6 applies the Fourier transformation to the measured time-lapse thermal distributions and transforms the signal into the spectral domain and then to filter the thermal noise from the spectral frequency component located at the predetermined lock-in frequency.

The time correlation between the exposure conditions retrieved from the EM signal detected by the EM sensor 11 or imposed by the processing unit 6 through the control link 26 or through the APP layer and the thermal signal detected by the thermal sensor allows implementation of the transient thermography technique (also referred as the "lock-in technique") in the post-processing of the measured thermal distribution in the screen. This technique allows reliable detection of the heat induced in the screen with magnitude comparable to or even lower than the thermal noise level.

With reference to figures 5 and 6, the operation of the device of figure 2 and figure 4 are detailed below.

During the test, the EM source 2 is placed at a distance $D_1$ from the screen. The EM source 2 operates at a frequency $F_1 \in [F_1^{min}, F_1^{max}]$ divided in multiple frequency channels having a predetermined bandwidth. The EM source is capable of multiplexing in frequency, time, and spatial domains by dynamically changing the frequency channels, time and spatial modulation schemes and/or radiation pattern. The EM source comprises a single antenna which is configured to emit at least two different radiation beams characterized by angular radiation patterns, gain and main beam direction. The incident angle $\theta$ of the EM fields radiated by the EM source and incident on the top surface of the screen can be estimated as a function of the relative position of the emitting antenna and the distance D1.

The screen 3 may be any one of the structures described in figure 3. The device comprises a thermal sensor placed on the opposite side of the screen at certain distance $D_2$ defined with respect to its field of view which at least covers a portion of the bottom surface of the screen.

In figure 5, the first beam and the second beam are incident on the top surface 31 of the screen respectively with an oblique angle $\theta_1, \theta_2$. The thermal sensor 5 is placed in a manner to cover at least a portion of the area illuminated by the EM source.

When the top surface 31 of the screen is illuminated by the EM field emitted by the source 2, a portion of the EM wave is reflected from the upper surface 31 of the dielectric layer 3 and a portion of the EM wave is transmitted through and absorbed at least partly along the propagation path inside the screen. The absorbed portion of the EM wave induces a temperature rise in the screen, leading to creation of a heat distribution at the bottom surface of the screen.

Figure 6 represents an exemplary temperature distribution profile or heat pattern $G_{\Sigma}(\xi, \tau)$ induced at the bottom surface of the screen after a short exposure time, whose duration is defined by $\tau$ measured in time units. The space parameter $\xi$ can represent either x or y coordinate, in the bottom surface of the screen. This pattern can be measured at any time moment $\tau_i \in (0, \tau)$ by the thermal sensor 5. In a preferred embodiment, the thermal sensor 5 is an IR image sensor.

The thick solid curve $G_\Sigma$ represents a measured temperature profile. The two thin dotted curves $G_1$, $G_2$ represent temperature patterns associated with two overlapping hot spots induced by the absorbed EM fields retrieved through decomposition of the measured profile. The two thin solid curves $F_1$, $F_2$ represent estimated temperature profiles that would have been induced in the screen with zero thermal conductivity.

Knowing the relative position of the emitting antenna attached to or embedded in the EM source 2, the distances $D_1$ and $D_2$, the physical parameters of the screen, e.g. shape, thickness $T_s$, and effective complex dielectric permittivity of the screen medium at the operating frequency of the EM source, and thermal properties of the screen, e.g. thermal conductivity, heat capacity, and IR emissivity, one skilled in the art by applying the Maxel and the heat equations can calculate the EM power locally absorbed in the screen as a function of the heat dynamics measured at the corresponding surface area defined, for instance, by a unit cell area. This embodiment allows to estimate the exposure level caused by the EM radiation absorbed in the screen during a predetermined duration of the test under assumption that the EM resource allocation remained fixed and unchanged. The retrieved dosimetric quantity (e.g. absorbed power density) can be then calculated for any surface area. The obtained data can further be used to retrieve the exposure level that could have been received by a user under the same exposure conditions by scaling.

The scaling factor can be determined by comparing the magnitude of the EM reflection coefficient from the surface and absorption in the screen medium and in a biological tissue (e.g. human skin tissue). The former can be defined analytically, numerically (through the full-wave EM simulations), or experimentally. The latter (EM properties of biological tissues at different frequencies) is known from the scientific literature or can be measured using commercially available EM characterization techniques (e.g. coaxial probes).

In another embodiment, the EM source 2 is capable of multiplexing in frequency, time, and spatial domains by dynamically changing the frequency channels and waveform of the emitted signals. The device of figure 4 can be used to determine the exposure level of a reference object represented by the screen.

The EM sensor measures the incident EM fields, e.g. its incident power, amplitude and/or phase of the E or H field. The received signal is then transmitted to the processing unit 6 which retrieves, through a post-processing procedure, information relative to the EM field emitted by the source. For instance, this information may concern the frequency channel used by the EM source, the time domain multiplexing information, and/or the incident power density in the specific location of the EM sensor. These data can be then used to determine at least a portion of information relative to the EM field emitter by the EM source at each time moment of the test.

For instance, it can be used to determine at which time intervals (during the test duration) the screen was exposed by a first and a second beams, at which frequency, and with which incident power (absolute or relative). This information then can be used to estimate the partial contributions of different EM source operation modes to the overall heat distribution measured by the thermal sensor. Moreover, the knowledge about the time domain multiplexing can be used to interpret the heat dynamics taking into account the heat spread along the bottom surface of the screen due to the finite thermal conductivity of the screen medium. For instance, if the first and the second spatial beams were used sequentially in time, so that the first beam was used during a time interval $t \in [0, \tau_0]$ and then followed by the second beam used during a time interval $t \in [\tau_0, \tau]$, then a stronger distortion of the measured temperature distribution due to the heat spread can be expected for the first beam due to a longer time between the excitation and IR measurements.

Finally, the processing unit 6 is configured to process the data from the thermal sensor and the data from the EM sensor 11, taking into account the time correlation between the exposure conditions detected based on the information obtained by the EM sensors and the heat dynamics measured by the thermal sensors. Thus, the information relative to the EM field detected by the EM sensor can be correlated with the information relative to the rise temperature distribution detected by the thermal sensor to retrieve dosimetric quantities relative to a user exposure level by the EM source.

With reference to figure 8 and 9, a method 200 for detecting the dosimetric quantity received by an object illuminated by an electromagnetic (EM) field emitted by an electromagnetic source is described below. The method 200 is implemented using the device of figure 4 described above.

The method comprises a first phase corresponding to a measurement phase comprising the following steps.

At step 201 (S1), the EM field 23 is emitted by the source 2 in the direction of the top surface of the thermal screen. In this embodiment, at least a part of the information relative to the resource allocation used by the source 2 to generate the EM field is unknown.

At step 202 (S2), the EM field 23 emitted by the source is converted into heat as a result of absorption of a portion of the EM field in the medium of the screen 3.

At step 203a (S3a), the thermal sensor 6 acquires information relative to the heat induced in the screen at a plurality of time moments. This step may comprise a step of measuring of a physical quantity proportional to the induced heat by at least one thermal sensor 5. In one embodiment, the thermal sensor may be an infrared image sensor and the physical quantity may be the intensity of the infrared radiation emitted from the bottom surface 32 of the thermal screen. In another embodiment, the bottom surface 32 is covered with a thermosensitive material and the thermal sensor is an image sensor, the physical quantity may be the intensity of the visible light radiation emitted or reflected by the bottom surface 32 of the screen. In yet another embodiment, the thermal sensors 5 comprises a plurality of thermocouples attached to or embedded in the bottom surface 32 of the screen, the physical quantity may be a voltage measured by a voltmeter. The information related to the heat can be stored in the memory unit 7 and/or displayed by the interface unit 8.

At step 203b (S3b), the EM sensor 11 continuously acquires information relative to the EM field emitted by the source 2 at the same time moments as the thermal sensor 5. The information relative to the EM field emitted by the source may comprise any portion of information related to the radio resource allocation by the source in the frequency, time and/or spatial domains.

As illustrated in figure 8, the duration of this first phase is limited by a time interval $[\tau_1, \tau_3]$, where $\tau_3$ is the switch off time of the source 2. In one embodiment, this termination time can be defined based on feedback from the processing unit 6 signaling a successful termination of the calculation process. The steps S3a and S3b of measuring the information relative to the heat and EM fields are also performed during the same interval of time $[\tau_1, \tau_3]$. The measured raw data (relative to a physical quantity related to the induced heat) and the postprocessed data (related to the time-lapse temperature rise distribution and to the EM field incident on the screen) is stored in the memory unit 7. A portion of this information for a period of time $[\tau_1, \tau_2]$ used for calculating the sought dosimetric quantity by the processing unit 6. The duration of this time interval can be continuously increased depending on the success of the calculation procedure that requires sufficient SNR for the heat measurements as well as sufficient information relative to the EM field. The step S3a and the step S3b are synchronized in time. The two steps shall start at the same time $\tau_1$, correspond to the same time moments during the same time interval.

The second phase correspond to a postprocessing phase and comprises the following steps.

At step 204a (S4a), the processing unit 6 calculates the information relative to the induced heat to reconstruct heat distributions at the bottom surface 32 of the thermal screen 3 at different time moments during the time interval $[\tau_1, \tau_2]$, referred time-lapsed heat distributions at a set of time moments. Depending on the type of the thermal sensor used, this step may comprise the following intermediate steps of :

- time averaging for a period of $\Delta\tau$;
- space averaging for a unit surface area of the bottom surface 32;
- converting a physical quantity measured by the thermal sensor into heat distribution along the bottom surface 32 of the thermal screen defined in terms of the absolute temperature or a relative temperature rise at a set of time moments during the exposure.

At step 204b (S4b), the processing unit 6 calculates the information relative to the EM field emitted by the source 2 to reconstruct illumination conditions at the top surface 31 of the screen 3 at the time moments $\tau_i \in [\tau_1, \tau_2]$ correlated with the time-lapsed heat measurements.

Depending on the portion of information available, this step may comprise the following intermediate steps of:

- calculating the screen medium EM characteristics at the operational frequency of the source 2 defined with respect to the frequency resource allocation;
- calculating the propagation path and loss between the source 2 and the thermal screen 3:
- calculating the reflection/transmission at the top surface of screen 3 for the given polarization and incidence angle defined by the relative position of the source 2;
- time/space averaging of the incident power density per unit surface area and per unit time interval.

The phase 2 can be started at an arbitrary time moment $\tau_2 (\tau_1 < \tau_2 \le \tau_3)$. In the embodiment of figure 9, the starting time is fixed and predetermined.

The duration of the postprocessing of the information related to the heat and of the information related to the EM field can be different and is defined by $\tau_h$ and $\tau_{em}$ respectively. Thus, the switch off time of the source 2 is defined by $\tau_3 = \tau_2 + \max(\tau_h, \tau_{em}) + \tau_c$.

The third phase comprises the following step.

At step 205, the processing unit 6 calculates the dosimetric quantity, using the information related to the induced heat, the information relative to the EM field, and the predetermined thermal and electromagnetic properties related to the screen 3 at the frequency of the source 2. The processing unit correlates in time the time-lapsed heat distribution calculated in step 204a with information related to the illumination conditions of the top surface of the screen calculated in step 204b and calculates the EM dosimetric quantity associated with the EM radiation incident on and absorbed by the screen at each point of measurement, pixel or cell unit.

The calculated data with a time tag comprising at least the duration of the exposure defined by the time interval of $[\tau_1, \tau_2]$ can be stored by the unit memory 7 and/or displayed by the interface unit 8.

With reference to figure 8 and 10, a method 300 according to another embodiment for detecting the dosimetric quantity received by an object illuminated by an electromagnetic (EM) field emitted by an electromagnetic source is described below. The method 300 is implemented using the device of figure 4 described above.

The method comprises a first phase corresponding to a measurement phase comprising the following steps.

At step 301 (S1), the EM field 23 is emitted by the source 2 in the direction of the top surface of the thermal screen. In this embodiment, at least a part of the information relative to the resource allocation used by the source 2 to generate the EM field is unknown.

At step 302 (S2), the EM field 23 emitted by the source is converted into heat as a result of absorption of a portion of the EM field in the medium of the screen 3.

At step 303a (S3a), the thermal sensor 6 acquires information relative to the heat induced in the screen at different time moments. This step may comprise a step of measuring of a physical quantity proportional to the induced heat by at least one thermal sensor 5. In one embodiment, the thermal sensor may be an infrared image sensor and the physical quantity may be the intensity of the infrared radiation emitted from the bottom surface 32 of the thermal screen. In another embodiment, the bottom surface 32 is covered with a thermosensitive material and the thermal sensor is an image sensor, the physical quantity may be the intensity of the visible light radiation emitted or reflected by the bottom surface 32 of the screen. In yet another embodiment, the thermal sensors 5 comprise a plurality of thermocouples attached to or embedded in the bottom surface 32 of the screen, the physical quantity may be a voltage measured by a voltmeter. The information related to the heat can be stored in the memory unit 7 and/or displayed by the interface unit 8.

At step 303b (S3b), the EM sensor 11 acquires information relative to the EM field emitted by the source 2. The information relative to the EM field emitted by the source may comprise any portion of information relative to the radio resource allocation by the source in the frequency, time and/r spatial domains.

As illustrated in figure 8, the duration of this first phase is limited by a time interval $[\tau_1, \tau_3]$, where $\tau_3$ is the switch off time of the source 2. In one embodiment, this termination time can be defined based on feedback from the processing unit 6 signaling a successful termination of the calculation process. The steps S3a and S3b of measuring the information relative to the heat and EM fields are also performed during the same interval of time $[\tau_1, \tau_3]$. The measured raw data (relative to a physical quantity related to the induced heat) and the postprocessed data (related to the time-lapse temperature rise distribution and to the EM field incident on the screen) is stored in the memory unit 7. A portion of this information for a period of time $[\tau_1, \tau_2]$ used for calculating the sought dosimetric quantity by the processing unit 6. The duration of this time interval can be continuously increased depending on the success of the calculation procedure that requires sufficient SNR for the heat measurements as well as sufficient information relative to the EM field. The step S3a and the step S3b are synchronized in time. The steps shall start at the same time $\tau_1$, correspond to the same time moments during the same time interval.

Advantageously, in this embodiment, the duration of this phase can be adjusted in real-time depending on the success of the phase 2 and phase 3. The termination criterium for this phase can be defined with respect to a predetermined value of $\tau_3$ or based on the successful termination of the phase 3.

The second phase correspond to a postprocessing phase and comprises the following steps.

At step 304a (S4a), the processing unit 6 calculates the information relative to the induced heat to reconstruct heat distributions at the bottom surface 32 of the thermal screen 3 at different time moments during the time interval $[\tau_1, \tau_2]$, referred time-lapsed heat distributions at a set of time moments. Depending on the type of the thermal sensor used, this step may comprise the following intermediate steps of :

- time averaging for a period of $\Delta\tau$;
- space averaging for a unit surface area of the bottom surface 32;
- converting a physical quantity measured by the thermal sensor into heat distribution along the bottom surface 32 of the thermal screen defined in terms of the absolute temperature or a relative temperature rise at a set of time moments during the exposure.

At step 304b (S4b), the processing unit 6 calculates the information relative to the EM field emitted by the source 2 to reconstruct illumination conditions at the top surface 31 of the screen 3 at the time moments $\tau_i \in [\tau_1, \tau_2]$ correlated with the time-lapsed heat measurements.

Depending on the portion of information available, this step may comprise the following intermediate steps of:

- calculating the screen medium EM characteristics at the operational frequency of the source 2 defined with respect to the frequency resource allocation;
- calculating the propagation path and loss between the source 2 and the thermal screen 3:
- calculating the reflection/transmission at the top surface of screen 3 for the given polarization and incidence angle defined by the relative position of the source 2;
- time/space averaging of the incident power density per unit surface area and per unit time interval.

In a similar manner, the phase 2 can be started at an arbitrary time moment and this starting time $\tau_2$ can be fixed and predetermined or iteratively increased until successful termination of the third phase or until becomes equal to the total duration of the first phase. The increase of the starting time allows to increase the interval of the exposure time taken into consideration, and thus achieve a higher temperature rise in the heated zone, that may be necessary for achieving a desired threshold value of the signal-to-noise ratio (SNR) defined with respect to the thermal noise and/or sensitivity of the thermal sensor 5.

The duration of the postprocessing of the information related to the heat and of the information related to the EM field can be different and is defined by $\tau_h$ and $\tau_{em}$ respectively.

A success criterium for the step 304a can be defined with respect to the SNR level defined with respect to an acceptable threshold value that may guarantee a reliable interpretation of the measured thermal data. In case of insufficient SNR (SNR < threshold), an additional step for improving the SNR, such as transient thermography, can be applied as described below. In figure 10, this optional step is illustrated by a box surrounded by dotted line.

The transient thermography method for improving the SNR requires periodic excitation with a predetermined waveform. Knowing the excitation conditions (i.e. frequency and duration of the pulses), a Fourier-based filtering technique can be applied to filter the stationary thermal noise. This allows to significantly improve SNR and achieve a reliable readout of the thermal data buried by thermal noise. However, implementation of this method requires control over the resource allocation, at least regarding the operational frequency, waveform and radiation diagram that shall be predefined. This can be done through the control link 26 between the processing unit 6 and the source 2. In one embodiment, this control link can be represented by a wireless link established through EM sensor 11. Alternatively, it can be established through the application layer, provided that both the processing unit 6 and the source can be configured to support such connections.

The third phase (Phase 3) comprises the following step.

At step 305, the processing unit 6 calculates the dosimetric quantity, using the information related to the induced heat, the information relative to the EM field, and the electromagnetic and thermal properties of the screen 3 at the frequency of the source 2. The processing unit 6 correlates in time the time-lapsed heat distribution calculated in step 304a with information relative to the illumination conditions of the top surface of the screen calculated in step 304b and calculates the EM dosimetric quantity associated with the EM radiation incident on and absorbed by the screen at each point of measurement, pixel or cell unit.

The calculated data with a time tag comprising at least the duration of the exposure period defined by the time interval of $[\tau_1, \tau_2]$ can be stored by the memory unit 7 and/or displayed by the interface unit 8.

The success criterium for completion of Phase 3 can be defined with respect to convergence of the numerical solution of the time-reverse EM/thermal model used to calculate an EM dosimetric quantity (e.g. the absorbed power density or the absorbed energy density derived as the temporal integration of the absorbed power density) by the processing unit 6 for the time interval of $[\tau_1, \tau_2]$, based on the temperature rise distribution at a time moment $\tau_i \in [\tau_1, \tau_2]$ determined by the processing unit 6 based on the information relative to the induced heat measured by the thermal sensor 5 and processed by the processing unit 6 taking into account the screen exposure conditions during the time interval of

$[\tau_1, \tau_i]$ determined by the processing unit 6 based on the information relative to the EM field predetermined or acquired by the EM sensor 11 and the predetermined screen EM/thermal properties. Apart to known factors related to the convergence of the numerical solutions of the differential equations, such as the Maxwell and the heat equations, the convergence of the time-reverse EM/thermal model strongly depends on the accuracy in determination of the temperature rise distribution considered as the initial input data for the time-reverse simulation. For a given level of the ambient thermal noise, the accuracy in calculation of the temperature rise distribution can be improved by increasing the incident power density of the EM field, by increasing the exposure time defined by parameter $\tau_2$, and/or by using a predetermined waveform of the excitation signal emitted by the EM source 2 to allow a smart post-processing of the measured thermal data, such as the transient thermography with a predetermined lock-in frequency. The convergence criterium of the numerical solution can be defined with respect to a predetermined threshold for the relative change in the value of a calculated dosimetric quantity for iteratively increasing exposure time.

If the convergence criterium is reached, the measurement procedure can be terminated with the total execution time $\tau_3 = \tau_2 + \max(\tau_h, \tau_{em}) + \tau_c$, where $\tau_h$ is the time needed to postprocess the information relative the induced heat, and $\tau_{em}$ is the time needed to postprocess the information relative the EM field emitted by the source 2, and $\tau_c$ is the time needed to complete the third phase 3 of solving the EM/thermal time-reverse model.

If the convergence criterium is not reached, the following additional steps can be implemented:

- a longer data set of information related to the heat and EM field corresponding to a longer exposure time can be processed. This can be done by increasing the value of the parameter $\tau_2$, or by restarting the measurements using another resource allocation to enabling smart post-processing of the thermal data thus improving the SNR and, consequently, the convergence of the algorithm. The new resource allocation may concern a specific radiation diagram (beam-forming) and/or use of a certain frequency and/or waveform leading to better SNR for the thermal signal through a better EM-to-heat conversion efficiency or a more localized exposure.

## Claims

1. Device (1) for measuring an electromagnetic dosimetric quantity received by an object illuminated by an electromagnetic (EM) field (23) emitted by an electromagnetic source (2), comprising:

    - a screen (3) comprising a top surface (31) faced to the electromagnetic source (2) and a bottom surface (32) opposite to the top surface (31), said screen (3) being adapted to absorb at least a portion of the EM field emitted by the electromagnetic source (2);

- the screen comprising a plurality of unit cells (33);

- at least one thermal sensor (5) arranged relative to the bottom surface of the screen (3) and configured to measure a physical quantity relative to the heat distribution along a surface of the screen induced due to the absorption of the electromagnetic field in the screen medium;

- at least one electromagnetic sensor (11) configured to measure the information relative to the EM field emitted by the EM source;

- a processing unit (6) linked to the at least one thermal sensor (5) and to the at least one electromagnetic sensor (11), configured to calculate in a synchronized manner the electromagnetic dosimetric quantities from the measured heat distribution, the information relative to the EM field emitted by the EM source (2), and the predetermined EM and thermal properties of the screen (3).

**2.** Device of claim 1, wherein the processing unit (6) is configured to correlate in time the information relative to the EM field measured by the at least one electromagnetic sensor (11) and the heat distribution measured by the at least one thermal sensor (5) to calculate the electromagnetic dosimetric quantities.

**3.** Device of claim 1 or 2, wherein the processing unit (6) is configured to analyze the signal transmitted from the at least one electromagnetic sensor (11) to retrieve the information relative to the EM field emitted by the EM source (2), and wherein the at least one electromagnetic sensor (11) is configured to measure the incident EM field (23) from the EM source, the EM field reflected from the top surface of the screen, or the EM field transmitted through the screen.

**4.** Device of any of claim 1 to 3, wherein the at least one electromagnetic sensor (11) is linked to the electromagnetic source (2) by a control link (26).

**5.** Device of any of claims 1 to 4, wherein the processing unit (6) is configured to use a lock-in technique to postprocess the time-lapse heat distributions by using information relative to the resource allocation by the EM source (2).

**6.** Device of any of claims 1 to 5, wherein the at least one thermal sensor (5) is an image sensor positioned at a distance from the bottom surface of the screen and aligned with respect to the screen center, so that its field of view covers at least a portion of the bottom surface.

**7.** Device of any of claims 1 to 5, wherein the at least one thermal sensor (5) comprises a plurality of thermocouples attached to or embedded in the bottom surface of the thermal screen.

**8.** Device of any of claims 1 to 6, wherein the at least one thermal sensor (5) comprises at least one thermosensitive element, attached to the bottom surface of the screen.

**9.** Device of any of claims 1 to 8, wherein the screen (3) comprises at least one first dielectric layer (3) comprising a top surface (31) faced to the electromagnetic source (2) and a bottom surface (32) opposite to the top surface (31);

- said top surface (31) being at least partly transparent to the electromagnetic fields emitted by the source (2);
- said bottom surface (32) being at least partly reflecting for the electromagnetic fields transmitted through the at least one first dielectric layer (3);
- said at least one first dielectric layer (3) **characterized by** a complex dielectric permittivity and a thickness jointly chosen to reproduce the electromagnetic response of a reference object, e.g. a biological tissue, a human skin tissue.

**10.** Device of any of claims 1 to 8, wherein the thermal screen comprises two dielectric layers (41, 42), the first dielectric layer (41) having a top surface faced to the electromagnetic sensor (2) and the second dielectric layer (42) having a bottom surface faced to the thermal sensor (5), each layer **characterized by** a complex dielectric permittivity and thickness jointly chosen to reproduce the electromagnetic response of a reference object, each layer comprising a plurality of unit cells.

**11.** Device of any of claims 1 to 8, wherein the screen (3) comprises two dielectric layers (51, 52), the first dielectric layer (51) having a top surface faced to the electromagnetic sensor (2) and the second dielectric layer (52) having a bottom surface faced to the thermal sensor (5), each layer **characterized by** a complex dielectric permittivity and thickness jointly chosen to reproduce the electromagnetic response of a reference object, each layer comprising a plurality of unit cells, the unit cells being separated by groves (54), the groves being filled in or made of a dielectric material having a thermal conductivity smaller than that of the dielectric material of the second dielectric layer (52).

**12.** Device of any of claims 1 to 11, wherein the screen comprises a first dielectric layer (61), a second dielectric layer (62) and a third layer (63), the second layer (62) is made of a dielectric material having a thermal conductivity smaller than that of the third layer, each layer **characterized by** a complex dielectric permittivity and thickness jointly chosen to reproduce the electromagnetic response of a reference object, each layer comprising a plurality of unit cells, the unit cells of the third layer being separated by groves (64), the groves being filled in or made of a dielectric material having a thermal conductivity smaller than that of the dielectric material of the third dielectric layer (63).

**13.** Device of any of claims 1 to 11, wherein the screen comprises a first dielectric layer (71), a second dielectric layer (72) and a third layer (73), each layer **characterized by** a complex dielectric permittivity and thickness jointly chosen to reproduce the electromagnetic response of a reference object, each layer comprising a plurality unit cells, the unit cells of the second layer (72) being separated by groves (74), the groves being filled in or made of a dielectric material having a thermal conductivity smaller than that of the dielectric material of the second dielectric layer (72), the third layer (73) being made of a thermosensitive material.

**14.** Device of any of claims 1 to 13, wherein the thermal screen (3) comprises at least one dielectric layer, said at least one layer comprising a plurality of unit cells forming a structure having a constant thickness or a variable thickness, planar or curved, shaped to reproduce a 3D form.

**15.** A method of detecting an electromagnetic dosimetric quantity received by an object illuminated by an electromagnetic (EM) field emitted by an electromagnetic source by using a device of any of claims 1 to 14, the method comprising :

- illuminating, using an EM source (2), a surface of a thermal screen (3) ;
- converting the EM field incident on the surface of the thermal screen (3) into heat induced in the thermal screen (3);
- measuring the information relative to the heat induced in the screen (3) by the at least one thermal sensor (5);
- measuring the information relative to the EM field, emitted by the EM source (2), by an EM sensor (11);
- determining a time-lapsed temperature rise distribution at a set of time moments $\tau_i$ in a time interval $[\tau_1 , \tau_2]$ by a processing unit (6) using information relative to the induced heat;
- correlating in time the information relative to the time-lapsed temperature rise distribution and the information relative to the EM field emitted by the EM source;
- calculating the time and/or spatial averaged electromagnetic dosimetric quantities using correlated in time information relative to the time-lapsed temperature rise distribution and to the EM field emitted by the EM source, and the predetermined information relative to the EM and thermal properties of the thermal screen (3).

**16.** Method according to claim 15 further comprising a step:

- comparing the signal to noise ratio (SNR) of the time-lapsed temperature rise distribution to a predetermined threshold value;
- improving the SNR by using the information relative to the EM field and the information relative to the induced heat of the screen;
- completion of the measurement procedure defined with respect to the convergence of a numerical solution of a time-reverse EM and thermal model used for calculating the EM dosimetric quantities.

**Patentansprüche**

**1.** Vorrichtung (1) zum Messen einer elektromagnetischen dosimetrischen Größe, die von einem durch ein von einer elektromagnetischen Quelle (2) ausgesandtes elektromagnetisches (EM) Feld (23) beleuchteten Objekt empfangen wird, umfassend:
einen Schirm (3) umfassend eine Oberseite (31), die zur elektromagnetischen Quelle (2) gerichtet ist, und eine Unterseite (32), die der Oberseite (31) gegenüberliegt, wobei der Schirm (3) dazu ausgelegt ist, mindestens einen Teil des von der elektromagnetischen Quelle (2) ausgesandten EM-Feldes zu absorbieren;
wobei der Schirm eine Vielzahl von Einheitszellen (33) umfasst;

mindestens einen Wärmesensor (5), der relativ zur Unterseite des Schirms (3) angeordnet ist und dazu konfiguriert ist, eine physikalische Größe bezüglich der entlang einer Oberfläche des Schirms infolge der Absorption des elektromagnetischen Feldes im Schirmmedium induzierten Wärmeverteilung zu messen;
mindestens einen elektromagnetischen Sensor (11), der dazu konfiguriert ist, die Information bezüglich des von der EM-Quelle ausgesandten EM-Feldes zu messen;
eine Verarbeitungseinheit (6), verbunden mit dem mindestens einen Wärmesensor (5) und den mindestens einen elektromagnetischen Sensor (11), welche dazu konfiguriert ist, auf synchronisierte Weise die elektromagnetischen dosimetrischen Größen aus der gemessenen Wärmeverteilung, die Information bezüglich des von der EM-Quelle (2) ausgesandten EM-Feldes und die vorbestimmten EM- und Wärmeeigenschaften des Schirms (3) zu berechnen.

2. Vorrichtung gemäß Anspruch 1, wobei die Verarbeitungseinheit (6) dazu konfiguriert ist, die durch den mindestens einen elektromagnetischen Sensor (11) gemessene Information bezüglich des EM-Feldes und die durch den mindestens einen Wärmesensor (5) gemessene Wärmeverteilung zeitlich zu korrelieren, um die elektromagnetischen dosimetrischen Größen zu berechnen.

3. Vorrichtung gemäß Anspruch 1 oder 2, wobei die Verarbeitungseinheit (6) dazu konfiguriert ist, das von dem mindestens einen elektromagnetischen Sensor (11) übertragene Signal zu analysieren, um die Information bezüglich des von der EM-Quelle (2) ausgesandten EM-Feldes zu erhalten, und wobei der mindestens eine elektromagnetische Sensor (11) dazu konfiguriert ist, das von der EM-Quelle stammende einfallende EM-Feld (23), das von der Oberseite des Schirms reflektierte EM-Feld oder das durch den Schirm hindurchtretende EM-Feld zu messen.

4. Vorrichtung gemäß einem der Ansprüche 1 bis 3, wobei der mindestens eine elektromagnetische Sensor (11) durch eine Steuerverbindung (26) mit der elektromagnetischen Quelle (2) verbunden ist.

5. Vorrichtung gemäß einem der Ansprüche 1 bis 4, wobei die Verarbeitungseinheit (6) dazu konfiguriert ist, eine Lock-in-Technik einzusetzen, um die zeitaufgelösten Wärmeverteilungen nachzuverarbeiten, wobei Information bezüglich der Ressourcenallokation durch die EM-Quelle (2) verwendet wird.

6. Vorrichtung gemäß einem der Ansprüche 1 bis 5, wobei der mindestens eine Wärmesensor (5) ein Bildsensor ist, der in einem Abstand von der Unterseite des Schirms angeordnet und bezüglich des Schirmzentrums ausgerichtet ist, sodass sein Sichtfeld mindestens einen Teil der Unterseite abdeckt.

7. Vorrichtung gemäß einem der Ansprüche 1 bis 5, wobei der mindestens eine Wärmesensor (5) eine Vielzahl von Thermoelementen umfasst, die an der Unterseite des thermischen Schirms angebracht oder in diese eingebettet sind.

8. Vorrichtung gemäß einem der Ansprüche 1 bis 6, wobei der mindestens eine Wärmesensor (5) mindestens ein thermosensitives Element umfasst, das an der Unterseite des Schirms angebracht ist.

9. Vorrichtung gemäß einem der Ansprüche 1 bis 8, wobei der Schirm (3) mindestens eine erste dielektrische Schicht (3) umfasst, die eine Oberseite (31), welche zur elektromagnetischen Quelle (2) gerichtet ist, und eine Unterseite (32), die der Oberseite (31) gegenüberliegt, aufweist;

wobei die Oberseite (31) zumindest teilweise transparent für die von der Quelle (2) ausgesandten elektromagnetischen Felder ist; wobei die Unterseite (32) zumindest teilweise reflektierend für die durch die mindestens eine erste dielektrische Schicht (3) hindurchgegangenen elektromagnetischen Felder ist; wobei die mindestens eine erste dielektrische Schicht (3) durch eine komplexe dielektrische Permittivität und eine Dicke gekennzeichnet ist, die gemeinsam ausgewählt sind, um das elektromagnetische Antwortverhalten eines Referenzobjekts, z. B. eines biologischen Gewebes oder menschlichen Hautgewebes, nachzubilden.

10. Vorrichtung gemäß einem der Ansprüche 1 bis 8, wobei der thermische Schirm zwei dielektrische Schichten (41, 42) umfasst, wobei die erste dielektrische Schicht (41) eine Oberseite aufweist, die zum elektromagnetischen Sensor (2) gerichtet ist, und die zweite dielektrische Schicht (42) eine Unterseite aufweist, die zum Wärmesensor (5) gerichtet ist, wobei jede Schicht durch eine komplexe dielektrische Permittivität und eine Dicke gekennzeichnet ist, die gemeinsam ausgewählt sind, um das elektromagnetische Antwortverhalten eines Referenzobjekts nachzubilden, wobei jede Schicht eine Vielzahl von Einheitszellen umfasst.

11. Vorrichtung gemäß einem der Ansprüche 1 bis 8, wobei der Schirm (3) zwei dielektrische Schichten (51, 52) umfasst, wobei die erste dielektrische Schicht (51) eine Oberseite aufweist, die zum elektromagnetischen Sensor (2) gerichtet ist, und die zweite dielektrische Schicht (52) eine Unterseite aufweist, die zum Wärmesensor (5) gerichtet ist, wobei jede Schicht durch eine komplexe dielektrische Permittivität und eine Dicke gekennzeichnet ist, die gemeinsam ausgewählt sind, um das elektromagnetische Antwortverhalten eines Referenzobjekts nachzubilden, wobei jede Schicht eine Vielzahl von Einheitszellen umfasst, wobei die Einheitszellen durch Nuten (54) voneinander getrennt sind, wobei die Nuten mit einem dielektrischen Material ausgefüllt sind oder daraus bestehen, das eine geringere Wärmeleitfähigkeit als das dielektrische Material der zweiten dielektrischen Schicht (52) aufweist.

**12.** Vorrichtung gemäß einem der Ansprüche 1 bis 11, wobei der Schirm eine erste dielektrische Schicht (61), eine zweite dielektrische Schicht (62) und eine dritte Schicht (63) umfasst, wobei die zweite Schicht (62) aus einem dielektrischen Material besteht, das eine geringere Wärmeleitfähigkeit als die dritte Schicht aufweist, wobei jede Schicht durch eine komplexe dielektrische Permittivität und eine Dicke gekennzeichnet ist, die gemeinsam ausgewählt sind, um das elektromagnetische Antwortverhalten eines Referenzobjekts nachzubilden, wobei jede Schicht eine Vielzahl von Einheitszellen umfasst, wobei die Einheitszellen der dritten Schicht durch Nuten (64) voneinander getrennt sind, wobei die Nuten mit einem dielektrischen Material ausgefüllt sind oder daraus bestehen, das eine geringere Wärmeleitfähigkeit als das dielektrische Material der dritten dielektrischen Schicht (63) aufweist.

**13.** Vorrichtung gemäß einem der Ansprüche 1 bis 11, wobei der Schirm eine erste dielektrische Schicht (71), eine zweite dielektrische Schicht (72) und eine dritte Schicht (73) umfasst, wobei jede Schicht durch eine komplexe dielektrische Permittivität und eine Dicke gekennzeichnet ist, die gemeinsam ausgewählt sind, um das elektromagnetische Antwortverhalten eines Referenzobjekts nachzubilden, wobei jede Schicht eine Vielzahl von Einheitszellen umfasst, wobei die Einheitszellen der zweiten Schicht (72) durch Nuten (74) voneinander getrennt sind, wobei die Nuten mit einem dielektrischen Material ausgefüllt sind oder daraus bestehen, das eine geringere Wärmeleitfähigkeit als das dielektrische Material der zweiten dielektrischen Schicht (72) aufweist, wobei die dritte Schicht (73) aus einem thermosensitiven Material besteht.

**14.** Vorrichtung gemäß einem der Ansprüche 1 bis 13, wobei der thermische Schirm (3) mindestens eine dielektrische Schicht umfasst, wobei die mindestens eine Schicht eine Vielzahl von Einheitszellen aufweist, die eine Struktur mit konstanter oder variabler Dicke, planar oder gekrümmt, bilden, die so gestaltet ist, dass sie eine 3D-Form nachbildet.

**15.** Verfahren zum Nachweisen einer elektromagnetischen dosimetrischen Größe, die von einem Objekt empfangen wird, das durch ein von einer elektromagnetischen Quelle ausgesandtes elektromagnetisches (EM) Feld beleuchtet wird, unter Verwendung einer Vorrichtung gemäß einem der Ansprüche 1 bis 14, umfassend:

Beleuchten einer Oberfläche eines thermischen Schirms (3) mittels einer EM-Quelle (2);
Umwandeln des auf die Oberfläche des thermischen Schirms (3) auftreffenden EM-Feldes in Wärme, die im thermischen Schirm (3) induziert wird;
Messen der Information bezüglich der im Schirm (3) induzierten Wärme durch den mindestens einen Wärmesensor (5);
Messen der Information bezüglich des von der EM-Quelle (2) ausgesandten EM-Feldes durch einen EM-Sensor (11);
Bestimmen einer zeitaufgelösten Temperaturanstiegsverteilung zu einer Menge von Zeitpunkten $\tau_i$ im Zeitintervall $[\tau_1, \tau_2]$ durch eine Verarbeitungseinheit (6) unter Verwendung von Information bezüglich der induzierten Wärme;
zeitliches Korrelieren der Information bezüglich der zeitaufgelösten Temperaturanstiegsverteilung und der Information bezüglich des von der EM-Quelle ausgesandten EM-Feldes;
Berechnen der zeitlich und/oder räumlich gemittelten elektromagnetischen dosimetrischen Größen unter Verwendung der zeitlich korrelierten Information bezüglich der zeitaufgelösten Temperaturanstiegsverteilung und des von der EM-Quelle ausgesandten EM-Feldes sowie der vorbestimmten Information bezüglich der EM- und thermischen Eigenschaften des thermischen Schirms (3).

**16.** Verfahren gemäß Anspruch 15, weiter umfassend einen Schritt:

Vergleichen des Signal-Rausch-Verhältnisses (SNR) der zeitaufgelösten Temperaturanstiegsverteilung mit einem vorbestimmten Schwellenwert;
Erhöhen des SNR unter Verwendung der Information bezüglich des EM-Feldes und der Information bezüglich der im Schirm induzierten Wärme;
Abschluss der Messprozedur, definiert im Hinblick auf die Konvergenz einer numerischen Lösung eines zeitinvertierten EM- und thermischen Modells, das zum Berechnen der EM-dosimetrischen Größen verwendet wird.

**Revendications**

**1.** Dispositif (1) de mesure d'une quantité dosimétrique électromagnétique reçue par un objet éclairé par un champ électromagnétique (EM) (23) émis par une source électromagnétique (2), comprenant :

- un écran (3) comprenant une surface supérieure (31) orientée vers la source électromagnétique (2) et une surface inférieure (32) opposée à la surface supérieure (31), ledit écran (3) étant conçu pour absorber au moins une partie du champ EM émis par la source électromagnétique (2) ;

- l'écran comprenant une pluralité de cellules unitaires (33) ;

- au moins un capteur thermique (5) agencé par rapport à la surface inférieure de l'écran (3) et configuré pour mesurer une quantité physique par rapport à la distribution de chaleur le long d'une surface de l'écran induite par l'absorption du champ électromagnétique dans le support écran ;

- au moins un capteur électromagnétique (11) configuré pour mesurer les informations relatives au champ EM émis par la source EM ;

- une unité de traitement (6) reliée à l'au moins un capteur thermique (5) et à l'au moins un capteur électromagnétique (11), configurée pour calculer de manière synchronisée les quantités dosimétriques électromagnétiques à partir de la distribution de chaleur mesurée, des informations relatives au champ EM émis par la source EM (2) et des propriétés EM et thermiques prédéterminées de l'écran (3).

2. Dispositif selon la revendication 1, dans lequel l'unité de traitement (6) est configurée pour corréler dans le temps les informations relatives au champ EM mesurées par l'au moins un capteur électromagnétique (11) et la distribution de chaleur mesurée par l'au moins un capteur thermique (5) pour calculer les quantités dosimétriques électromagnétiques.

3. Dispositif selon la revendication 1 ou 2, dans lequel l'unité de traitement (6) est configurée pour analyser le signal émis par l'au moins un capteur électromagnétique (11) pour extraire les informations relatives au champ EM émis par la source EM (2), et dans lequel l'au moins un capteur électromagnétique (11) est configuré pour mesurer le champ EM incident (23) de la source EM, le champ EM réfléchi par la surface supérieure de l'écran, ou le champ EM transmis à travers l'écran.

4. Dispositif selon l'une quelconque des revendications 1 à 3, dans lequel l'au moins un capteur électromagnétique (11) est relié à la source électromagnétique (2) par une liaison de commande (26).

5. Dispositif selon l'une quelconque des revendications 1 à 4, dans lequel l'unité de traitement (6) est configurée pour utiliser une technique de blocage pour post-traiter les distributions de chaleur en accéléré en utilisant des informations relatives à l'allocation de ressources par la source EM (2).

6. Dispositif selon l'une quelconque des revendications 1 à 5, dans lequel l'au moins un capteur thermique (5) est un capteur d'image positionné à une distance de la surface inférieure de l'écran et aligné par rapport au centre d'écran, de sorte que son champ de vision couvre au moins une partie de la surface inférieure.

7. Dispositif selon l'une quelconque des revendications 1 à 5, dans lequel l'au moins un capteur thermique (5) comprend une pluralité de thermocouples fixés à ou incorporés dans la surface inférieure de l'écran thermique.

8. Dispositif selon l'une quelconque des revendications 1 à 6, dans lequel l'au moins un capteur thermique (5) comprend au moins un élément thermosensible, fixé à la surface inférieure de l'écran.

9. Dispositif selon l'une quelconque des revendications 1 à 8, dans lequel l'écran (3) comprend au moins une première couche diélectrique (3) comprenant une surface supérieure (31) orientée vers la source électromagnétique (2) et une surface inférieure (32) opposée à la surface supérieure (31) ;

   - ladite surface supérieure (31) étant au moins partiellement transparente aux champs électromagnétiques émis par la source (2) ;
   - ladite surface inférieure (32) étant au moins partiellement réfléchissante pour les champs électromagnétiques émis à travers l'au moins une première couche diélectrique (3) ;
   - ladite au moins une première couche diélectrique (3) étant **caractérisée par** une permittivité diélectrique complexe et une épaisseur choisies conjointement pour reproduire la réponse électromagnétique d'un objet de référence, par exemple un tissu biologique, un tissu cutané humain.

10. Dispositif selon l'une quelconque des revendications 1 à 8, dans lequel l'écran thermique comprend deux couches diélectriques (41, 42), la première couche diélectrique (41) présentant une surface supérieure orientée vers le capteur électromagnétique (2) et la deuxième couche diélectrique (42) présentant une surface inférieure orientée vers le capteur thermique (5), chaque couche étant **caractérisée par** une permittivité diélectrique complexe et une épaisseur choisies conjointement pour reproduire la réponse électromagnétique d'un objet de référence, chaque couche comprenant une pluralité de cellules unitaires.

11. Dispositif selon l'une quelconque des revendications 1 à 8, dans lequel l'écran (3) comprend deux couches diélectriques (51, 52), la première couche diélectrique (51) présentant une surface supérieure face au capteur électromagnétique (2) et la deuxième couche diélectrique (52) présentant une surface inférieure face au capteur thermique (5), chaque couche étant **caractérisée par** une permittivité diélectrique complexe et une épaisseur choisies conjointement pour reproduire la réponse électromagnétique d'un objet de référence, chaque couche comprenant une pluralité de cellules unitaires, les cellules unitaires étant séparées par des rainures (54), les rainures étant remplies de ou en un matériau diélectrique présentant une conductivité thermique inférieure à celle du matériau diélectrique de la deuxième couche diélectrique (52).

12. Dispositif selon l'une quelconque des revendications 1 à 11, dans lequel l'écran comprend une première couche diélectrique (61), une deuxième couche diélectrique (62) et une troisième couche (63), la deuxième couche (62) étant en un matériau diélectrique présentant une conductivité thermique inférieure à celle de la troisième couche, chaque couche étant **caractérisée par** une permittivité diélectrique complexe et une épaisseur choisies conjointement pour reproduire la réponse électromagnétique d'un objet de référence, chaque couche comprenant une pluralité de cellules unitaires, les cellules unitaires de la troisième couche étant séparées par des rainures (64), les rainures étant remplies de ou en un matériau diélectrique présentant une conductivité thermique inférieure à celle du matériau diélectrique de la troisième couche diélectrique (63).

13. Dispositif selon l'une quelconque des revendications 1 à 11, dans lequel l'écran comprend une première couche diélectrique (71), une deuxième couche diélectrique (72) et une troisième couche (73), chaque couche étant **caractérisée par** une permittivité diélectrique complexe et une épaisseur choisies conjointement pour reproduire la réponse électromagnétique d'un objet de référence, chaque couche comprenant une pluralité de cellules unitaires, les cellules unitaires de la deuxième couche (72) étant séparées par des rainures (74), les rainures étant remplies de ou en un matériau diélectrique présentant une conductivité thermique inférieure à celle du matériau diélectrique de la deuxième couche diélectrique (72), la troisième couche (73) étant en un matériau thermosensible.

14. Dispositif selon l'une quelconque des revendications 1 à 13, dans lequel l'écran thermique (3) comprend au moins une couche diélectrique, ladite au moins une couche comprenant une pluralité de cellules unitaires formant une structure présentant une épaisseur constante ou une épaisseur variable, plane ou incurvée, formée pour reproduire une forme 3D.

15. Procédé de détection d'une quantité dosimétrique électromagnétique reçue par un objet éclairé par un champ électromagnétique (EM) émis par une source électromagnétique en utilisant un dispositif selon l'une quelconque des revendications 1 à 14, le procédé comprenant :

- l'éclairage, à l'aide d'une source EM (2), d'une surface d'un écran thermique (3) ;
- la conversion du champ EM incident sur la surface de l'écran thermique (3) en chaleur induite dans l'écran thermique (3) ;
- la mesure des informations relatives à la chaleur induite dans l'écran (3) par l'au moins un capteur thermique (5) ;
- la mesure des informations relatives au champ EM, émis par la source EM (2), par un capteur EM (11) ;
- la détermination d'une distribution d'élévation de température en accéléré à un ensemble de moments $\tau_i$ dans un intervalle de temps $[\tau_1, \tau_2]$ par une unité de traitement (6) à l'aide d'informations relatives à la chaleur induite ;
- la corrélation dans le temps des informations relatives à la distribution d'élévation de température en accéléré et des informations relatives au champ EM émis par la source EM ;
- le calcul des quantités dosimétriques électromagnétiques temporelles et/ou spatiales moyennes à l'aide d'informations corrélées en temps relatives à la distribution d'élévation de température en accéléré et au champ EM émis par la source EM, et des informations prédéterminées relatives aux propriétés EM et thermiques de l'écran thermique (3).

16. Procédé selon la revendication 15, comprenant en outre une étape :

- la comparaison du rapport signal/bruit (SNR) de la distribution d'élévation de température en accéléré à une valeur seuil prédéterminée ;
- l'amélioration du SNR en utilisant les informations relatives au champ EM et les informations relatives à la chaleur induite de l'écran ;
- la réalisation de la procédure de mesure définie vis-à-vis de la convergence d'une solution numérique d'un modèle EM et thermique inversé dans le temps utilisé pour le calcul des quantités dosimétriques EM.

EP 4 332 588 B1

Fig. 1

Fig. 2

**Fig. 3**

**Fig. 4**

**Fig. 5**

**Fig. 6**

**Fig. 7**

**Fig. 8**

**Phase 1**

201 — Illuminating a surface of a thermal screen with an EM field emitted by an EM source

202 — Converting the EM field incident on a surface of a thermal screen into heat

203a — Measuring the information relative to the heat induced in the thermal screen

203b — Measuring the information relative to the EM field emitted by the source

**Phase 2**

204a — Determining time-lapsed heat distributions at a set of time moments $\tau_i \in [\tau_1, \tau_2]$

204b — Determining the information related to the EM field incident on the screen during a time interval $[\tau_1, \tau_2]$

**Phase 3**

205 — Calculating a dosimetric quantity using correlated in time information relative to the time-lapsed heat distributions and to the EM field incident on the screen

Terminate

200

Fig. 9

29

301 — Illuminating a surface of a thermal screen with an EM field emitted by an EM source

302 — Converting the EM field incident on a surface of a thermal screen into heat

303a — Measuring the information relative to the heat induced in the thermal screen

**Phase 1**

203b — Measuring the information relative to the EM field emitted by the source

Increase time interval $\tau_2$ and/or request a new resource allocation by the EM source

304a — Determining time-lapsed heat distributions at a set of time moments $\tau_i \in [\tau_1, \tau_2]$

SNR

not — Improving SNR of time-lapse heat distribution using the information relative to the EM field

**Phase 2**  ok

304b — Determining the information related to the EM field incident on the screen during a time interval $[\tau_1, \tau_2]$

300

305 — Calculating a dosimetric quantity using correlated in time information relative to the time-lapsed heat distributions and to the EM field incident on the screen

**Phase 3**

not — Goal — reached → Terminate

**Fig. 10**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 20170173350 A

- US 10739392 B2

**Non-patent literature cited in the description**

- **Y. OKANO** ; **H. SHIMOJI**. Comparison Measurement for Specific Absorption Rate With Physically Different Procedure. *IEEE Transactions on Instrumentation and Measurement*, February 2012, vol. 61 (2), 439-446

- **K. SASAKI et al.** Design of a Skin Equivalent Phantom for Estimating Surface Temperature Elevation Due to Human Exposure to Electromagnetic Fields From 10 to 100 GHz. *IEEE Transactions on Electromagnetic Compatibility*, October 2021, vol. 63 (5), 1631-1639